# EUROPEAN PATENT APPLICATION

(11) **EP 4 546 987 A1**
(43) Date of publication of application: **30.04.2025**
(21) Application number: 23845335.1
(22) Date of filing: 13.07.2023
(51) Int. Cl.: H10K 50/10

(54) **DISPLAY PANEL AND PREPARATION METHOD THEREFOR, AND ELECTRONIC DEVICE**

(30) Priority: 26.07.2022 CN 202210895539
(71) Applicant: Huawei Technologies Co., Ltd., Shenzhen, Guangdong 518129 (CN)
(72) Inventor: LIU, Guohe, Shenzhen, Guangdong 518129 (CN); ZHANG, Junyong, Shenzhen, Guangdong 518129 (CN); CHEN, Zesheng, Shenzhen, Guangdong 518129 (CN); HE, Hu, Shenzhen, Guangdong 518129 (CN)
(74) Representative: Gill Jennings & Every LLP
(86) International application number: PCT/CN2023/107323
(87) International publication number: WO 2024/022123

(57) **Abstract**

Embodiments of this application disclose a display panel and a preparation method thereof, and an electronic device, and relate to the field of display technologies, to improve display brightness uniformity of a display panel. The display panel includes: a backplane, an anode layer and a transfer electrode that are located on the backplane, a light emission function layer and a cathode layer that are located on the anode layer and the transfer electrode and that are sequentially stacked, a cathode suppression layer, and an auxiliary cathode. The backplane includes an auxiliary signal line, configured to reduce a voltage drop of the cathode layer. The transfer electrode and the anode layer are disposed on a same layer, and the transfer electrode is electrically connected to the auxiliary signal line. The light emission function layer and the cathode layer are provided with a first opening. At least a part of the cathode suppression layer is located on the cathode layer, the cathode suppression layer is provided with a second opening, and the second opening at least partially overlaps the first opening, and exposes a part of a surface of the transfer electrode. At least a part of the auxiliary cathode is located in the first opening, the auxiliary cathode is connected to the cathode layer and the transfer electrode, and the auxiliary cathode does not overlap the cathode suppression layer.

## Description

This application claims priority to Chinese Patent Application No. 202210895539.2, filed with the China National Intellectual Property Administration on July 26, 2022 and entitled "DISPLAY PANEL AND PREPARATION METHOD THEREOF, AND ELECTRONIC DEVICE", which is incorporated herein by reference in its entirety.

### TECHNICAL FIELD

This application relates to the field of display technologies, and in particular, to a display panel and a preparation method thereof, and an electronic device.

### BACKGROUND

A display including an AMOLED (active matrix organic light emitting diode, active matrix organic light emitting diode) display screen (briefly referred to as a display below) has advantages of thinness, a light weight, bendability, high contrast, active light emission, a continuously adjustable light emission color, a high response speed, and high light emission efficiency, and gradually replaces an LCD (liquid crystal display, liquid crystal display) as a current mainstream display.

Based on light emission manners of displays, the displays are mainly classified into three types: a top-emission display, a bottom-emission display, and a double-sided-emission display.

Light emission of the top-emission display may not be affected by a backplane, and therefore the top-emission display has a high aperture ratio. To ensure light emission efficiency of the top-emission display, thickness of a top electrode (or a cathode) of the top-emission display is small, so that more light can pass through the top electrode. However, in this case, a resistance of the top electrode is large, and voltage drops (IR Drops) in different regions of the top electrode are different. Consequently, display brightness uniformity of the top-emission display is poor.

### SUMMARY

Embodiments of this application provide a display panel and a preparation method thereof, and an electronic device, to improve display brightness uniformity of a display panel.

To achieve the foregoing objectives, the following technical solutions are used in embodiments of this application.

According to a first aspect, a display panel is provided. The display panel includes: a backplane, an anode layer and a transfer electrode that are located on the backplane, a light emission function layer and a cathode layer that are located on the anode layer and the transfer electrode and that are sequentially stacked, a cathode suppression layer, and an auxiliary cathode. The backplane includes an auxiliary signal line. The transfer electrode and the anode layer are disposed on a same layer, and the transfer electrode is electrically connected to the auxiliary signal line. The light emission function layer and the cathode layer are provided with a first opening. At least a part of the cathode suppression layer is located on the cathode layer, the cathode suppression layer is provided with a second opening, and the second opening at least partially overlaps the first opening, and exposes a part of a surface of the transfer electrode. At least a part of the auxiliary cathode is located in the first opening, the auxiliary cathode is connected to the cathode layer and the transfer electrode, and the auxiliary cathode does not overlap the cathode suppression layer.

According to the display panel provided in some embodiments of this application, the auxiliary signal line is disposed on the backplane, the transfer electrode that is on the same layer as the anode layer and that is electrically connected to the auxiliary signal line is disposed, the light emission function layer and the cathode layer are provided with the first opening that exposes the part of the surface of the transfer electrode, the cathode suppression layer is provided with the second opening that at least partially overlaps the first opening, and the auxiliary cathode that is at least partially located in the first opening is disposed through the second opening, so that the auxiliary cathode may be used to connect the cathode layer to the transfer electrode, to implement an electrical connection between the cathode layer and the auxiliary signal line (the cathode layer and the auxiliary signal line are connected in parallel). In this way, a resistance of the cathode layer may be reduced by using the auxiliary signal line, and a difference between voltage drops in different regions of the cathode layer may be reduced, that is, the voltage drops in different regions of the cathode layer tend to be consistent, so that voltages of the cathode layer in an entire display region tend to be consistent. This helps improve uniformity and stability of voltage values of reference voltage signals received by different light emission devices, and improve uniformity of display brightness of the display panel.

In a possible implementation of the first aspect, the cathode suppression layer is located on the cathode layer. An outer boundary of an orthographic projection of the first opening on the backplane coincides with an inner boundary of an orthographic projection of the second opening on the backplane. The auxiliary cathode is located in the first opening, and abuts against a part that is of the cathode layer and that surrounds the first opening. In the foregoing disposing manner, it can be ensured that the auxiliary cathode is located in the first opening, and is basically not located in the second opening or basically is not lapped on the cathode suppression layer, to avoid protruding of the auxiliary cathode relative to the cathode suppression layer. This helps improve surface flatness of the display panel while an electrical connection between the cathode layer and the transfer electrode is implemented.

In a possible implementation of the first aspect, the cathode suppression layer is located on the cathode layer, and an outer boundary of an orthographic projection of the first opening on the backplane is located within an inner boundary range of an orthographic projection of the second opening on the backplane; or a part of the cathode suppression layer is located on the cathode layer, the other part of the cathode suppression layer covers a part of a side wall of the first opening, and an outer boundary of an orthographic projection of the first opening on the backplane intersects with an inner boundary of an orthographic projection of the second opening on the backplane. A part of the auxiliary cathode is located in the first opening, and the other part of the auxiliary cathode is lapped on the cathode layer. When the outer boundary of the orthographic projection of the first opening on the backplane intersects with the inner boundary of the orthographic projection of the second opening on the backplane, this helps increase a contact area between the auxiliary cathode and the cathode layer. In this way, while an electrical connection between the cathode layer and the transfer electrode is implemented, structural stability between the auxiliary cathode and the cathode layer can be enhanced, and reliability of the electrical connection between the auxiliary cathode and the cathode layer is improved. When the outer boundary of the orthographic projection of the first opening on the backplane is within the inner boundary range of the orthographic projection of the second opening on the backplane, this helps increase a contact area between the auxiliary cathode and the transfer electrode, and also helps increase the contact area between the auxiliary cathode and the cathode layer. In this way, while an electrical connection between the cathode layer and the transfer electrode is implemented, structural stability between the auxiliary cathode and the transfer electrode can be enhanced, reliability of the electrical connection between the auxiliary cathode and the transfer electrode is improved, the structural stability between the auxiliary cathode and the cathode layer is enhanced, and the reliability of the electrical connection between the auxiliary cathode and the cathode layer is improved.

In a possible implementation of the first aspect, when the cathode suppression layer is located on the cathode layer, and the outer boundary of the orthographic projection of the first opening on the backplane is located within the inner boundary range of the orthographic projection of the second opening on the backplane, an area of an orthographic projection of the auxiliary cathode on the backplane is greater than an area of a graphic enclosed by the outer boundary of the orthographic projection of the first opening on the backplane. In this way, an overlapping area between an orthographic projection of the auxiliary cathode on the backplane and an orthographic projection of the cathode layer on the backplane can be increased, and an area of the part that is of the auxiliary cathode and that is lapped on the cathode layer is increased. This not only helps enhance the structural stability and the electrical connection reliability between the auxiliary cathode and the cathode layer, but also enhances an impact degree of the auxiliary cathode on a resistance of the cathode layer, so that the resistance of the cathode layer is reduced by using the auxiliary cathode.

In a possible implementation of the first aspect, when the cathode suppression layer is located on the cathode layer, and the outer boundary of the orthographic projection of the first opening on the backplane is located within the inner boundary range of the orthographic projection of the second opening on the backplane, the part that is of the auxiliary cathode and that is lapped on the cathode layer is in a ring shape. When the part of the cathode suppression layer is located on the cathode layer, the other part of the cathode suppression layer covers the part of the side wall of the first opening, and the outer boundary of the orthographic projection of the first opening on the backplane intersects with the inner boundary of the orthographic projection of the second opening on the backplane, the part that is of the auxiliary cathode and that is lapped on the cathode layer is in a "C" shape or a "-" shape.

In a possible implementation of the first aspect, thickness of the auxiliary cathode is greater than or equal to thickness of the cathode layer. In embodiments of this application, the thickness of the auxiliary cathode can be flexibly adjusted, so that not only lapping impedance between the auxiliary cathode and the transfer electrode can be reduced, and the resistance of the cathode layer can be reduced by using the auxiliary cathode, but also a difference between voltage drops in different regions of the cathode layer can be further reduced through cooperation with the auxiliary signal line. This further improves the display brightness uniformity of the display panel.

In a possible implementation of the first aspect, the anode layer includes an anode. The display panel further includes a pixel definition layer located between the anode layer and the light emission function layer, where the pixel definition layer is provided with the first opening and a third opening that exposes a part of a surface of the anode. The light emission function layer is in contact with the anode through the third opening, and an inner boundary of an orthographic projection of the third opening on the backplane does not overlap an outer boundary of an orthographic projection of the auxiliary cathode on the backplane. In this way, light emitted by the light emission function layer may be sequentially emitted through the cathode layer and the cathode suppression layer, to avoid that the light emitted by the light emission function layer is blocked by the auxiliary cathode, and avoid affecting light emission efficiency of the light emission device and the display panel.

In a possible implementation of the first aspect, the inner boundary of the orthographic projection of the third opening on the backplane coincides with an outer boundary of an orthographic projection of the cathode suppression layer on the backplane, or is located within an outer boundary range of an orthographic projection of the cathode suppression layer on the backplane. In this way, it can be ensured that the inner boundary of the orthographic projection of the third opening on the backplane does not overlap the outer boundary of the orthographic projection of the auxiliary cathode on the backplane, to avoid adverse impact on the light emission efficiency of the light emission device and the display panel.

In a possible implementation of the first aspect, there are a plurality of auxiliary signal lines. Extension directions of the plurality of auxiliary signal lines are the same, or at least one auxiliary signal line extends in a first direction, and at least one auxiliary signal line extends in a second direction, where the first direction intersects with the second direction. When the extension directions of the plurality of auxiliary signal lines are the same, arrangement regularity of the auxiliary signal lines is improved, and line distribution design of the auxiliary signal lines is facilitated. When extension directions of a part of auxiliary signal lines are different, more auxiliary signal lines are disposed, distribution density of the auxiliary signal lines is improved, the resistance of the cathode layer is further reduced, and the difference between the voltage drops in different regions of the cathode layer is further reduced.

In a possible implementation of the first aspect, there are a plurality of transfer electrodes, a plurality of first openings, a plurality of second openings, and a plurality of auxiliary cathodes. The auxiliary signal line is electrically connected to at least one transfer electrode, the transfer electrode is disposed in correspondence with at least one first opening, the second opening is disposed in correspondence with at least one first opening, and the auxiliary cathode is disposed in correspondence with at least one first opening.

In a possible implementation of the first aspect, the plurality of transfer electrodes are evenly distributed, or the plurality of auxiliary cathodes are evenly distributed. This facilitates layout design of the transfer electrodes or the auxiliary cathodes, and helps simplify a preparation process of the display panel.

In a possible implementation of the first aspect, in a direction from at least one boundary of the display panel to a center of the display panel, distribution density of the transfer electrodes gradually increases, or distribution density of the auxiliary cathodes gradually increases. The distribution density of the transfer electrodes or the distribution density of the auxiliary cathodes is designed in a differentiated manner, so that in a direction from an edge location of the cathode layer to a central location of the cathode layer, an adjustment amount of the cathode layer gradually increases. This helps further reduce the difference between the voltage drops in different regions of the cathode layer, and further improve the display brightness uniformity of the display panel.

In a possible implementation of the first aspect, the backplane includes a plurality of subpixels arranged in an array shape. Both the transfer electrode and the auxiliary cathode are in a block shape, the transfer electrode and the auxiliary cathode are disposed in a one-to-one correspondence, and the auxiliary cathode is disposed around the at least one subpixel, or the transfer electrode is in a strip shape, the auxiliary cathode is in a strip shape, the transfer electrode and the auxiliary cathode are disposed in a one-to-one correspondence, and at least one row or at least one column of subpixels are disposed between two adjacent auxiliary cathodes.

In a possible implementation of the first aspect, the backplane includes: a substrate; and a semiconductor layer, at least one gate conducting layer, and at least one source/drain conducting layer that are sequentially stacked on the substrate. The auxiliary signal line is located in a target conducting layer, and the target conducting layer includes any layer in the at least one gate conducting layer and the at least one source/drain conducting layer. In other words, in embodiments of this application, the auxiliary signal line is disposed in an existing film layer of the backplane, and is formed synchronously with the existing film layer. In this way, an additional film layer can be avoided, increase of thickness of the display panel can be avoided, and increase of preparation processes and preparation costs of the display panel can be avoided.

In a possible implementation of the first aspect, there are a plurality of auxiliary signal lines. The gate conducting layer includes a plurality of gate lines that extend in a first direction and are sequentially arranged in a second direction, where the first direction is perpendicular to the second direction. At least a part of auxiliary signal lines extend in the first direction and are sequentially arranged in the second direction. At least one gate line is disposed between any two adjacent auxiliary signal lines, and/or the source/drain conducting layer includes a plurality of data lines that extend in the second direction and that are sequentially arranged in the first direction. At least a part of auxiliary signal lines extend in the second direction and are sequentially arranged in the first direction. At least one data line is disposed between any two adjacent auxiliary signal lines.

In a possible implementation of the first aspect, the cathode suppression layer is a light-transmitting film layer. In this way, the cathode suppression layer can have high light transmittance, to avoid affecting light emission efficiency of the display panel.

In a possible implementation of the first aspect, the display panel has a display region and a peripheral region surrounding the display region. The anode layer, the transfer electrode, the light emission function layer, the cathode suppression layer, and the auxiliary cathode are all located in the display region. The display panel further includes a reference voltage signal line that is located in the peripheral region and that surrounds at least a part of the display region, where a part of the cathode layer is located in the display region, and the other part of the cathode layer is located in the peripheral region and is electrically connected to the reference voltage signal line. The cathode layer may receive a reference voltage signal from the reference voltage signal line, so that the light emission device and the display panel work, and the display panel implements picture display.

In a possible implementation of the first aspect, the auxiliary signal line is electrically connected to the reference voltage signal line. This helps further make voltages of the cathode layer in the entire display region tend to be consistent, and further improve display brightness uniformity of the display panel.

In a possible implementation of the first aspect, the display panel further includes an encapsulation layer located on the cathode suppression layer and the auxiliary cathode, and a touch function layer located on the encapsulation layer. The touch function layer is integrated into the encapsulation layer, so that thickness, a weight, a frame size, costs, and the like of the display panel can be greatly reduced. In addition, when the display panel is used in a foldable product, folding of the foldable product is facilitated, and bending experience of the foldable product is improved. In addition, in embodiments of this application, the auxiliary signal line and the cathode layer are disposed in parallel, so that the voltages of the cathode layer in the entire display region tend to be consistent, and voltage fluctuation of the cathode layer is reduced. This can improve a signal-to-noise ratio of the touch function layer, and can further improve a water ripple phenomenon of the display panel. In addition, increase of thickness of the cathode layer or an organic layer can be avoided, to ensure that the display panel has high light emission efficiency and low power consumption.

According to a second aspect, a display panel preparation method is provided, where the preparation method includes: forming a backplane, where the backplane includes an auxiliary signal line; synchronously forming an anode layer and a transfer electrode on the backplane, where the transfer electrode is electrically connected to the auxiliary signal line; sequentially forming a light emission function layer and a cathode layer on the anode layer and the transfer electrode, where the light emission function layer and the cathode layer are provided with a first opening; forming a cathode suppression layer, where at least a part of the cathode suppression layer is located on the cathode layer, the cathode suppression layer is provided with a second opening, and the second opening at least partially overlaps the first opening, and exposes a part of a surface of the transfer electrode; and forming an auxiliary cathode, where at least a part of the auxiliary cathode is located in the first opening, the auxiliary cathode is connected to the cathode layer and the transfer electrode, and the auxiliary cathode does not overlap the cathode suppression layer.

In a possible implementation of the second aspect, the sequentially forming a light emission function layer and a cathode layer on the anode layer and the transfer electrode includes: sequentially forming a light emission function thin film and a cathode thin film on the anode layer and the transfer electrode; and performing, by using a laser process, ablation on parts that are of the light emission function thin film and the cathode thin film and that are opposite to the transfer electrode, to form the first opening, and obtain the light emission function layer and the cathode layer; or the sequentially forming a light emission function layer and a cathode layer on the anode layer and the transfer electrode includes: disposing a first mask on a side of the anode layer and the transfer electrode, where the first mask has a first stopper, and the first stopper blocks a part of the transfer electrode; and sequentially performing evaporation by using an evaporation process, to form the light emission function layer and the cathode layer, where the first opening is formed at a location that is on the light emission function layer and the cathode layer and that corresponds to the first stopper.

In a possible implementation of the second aspect, the forming a cathode suppression layer includes: disposing a second mask on a side of the cathode layer, where the second mask has a second stopper, and the second stopper blocks at least a part of the first opening; and forming the cathode suppression layer on the cathode layer by using the evaporation process, and forming the second opening at a location that is on the cathode suppression layer and that corresponds to the second stopper.

The display panel preparation method provided in any design manner of the second aspect is, for example, used to prepare the display panel according to any one of the first aspect. For technical effect brought by any design manner of the second aspect, refer to technical effect brought by different design manners of the first aspect. Details are not described herein again.

According to a third aspect, an electronic device is provided, where the electronic device includes a display panel and a circuit board electrically connected to the display panel. The display panel includes the display panel according to any one of the first aspect.

For technical effect brought by any design manner in the third aspect, refer to technical effect brought by different design manners of the first aspect. Details are not described herein again.

### BRIEF DESCRIPTION OF DRAWINGS

FIG. 1 is a diagram of a structure of an electronic device according to an embodiment of this application;
FIG. 2 is a diagram of a structure of a display panel according to an embodiment of this application;
FIG. 3 is a diagram of a structure of another display panel according to an embodiment of this application;
FIG. 4 is a diagram of a structure of another display panel according to an embodiment of this application;
FIG. 5 is a diagram of a structure of another display panel according to an embodiment of this application;
FIG. 6 is a diagram of a structure of another display panel according to an embodiment of this application;
FIG. 7 is a diagram of a structure of another display panel according to an embodiment of this application;
FIG. 8 is a partial top view of a region E on the display panel shown in FIG. 7;
FIG. 9 is a diagram of a structure of another display panel according to an embodiment of this application;
FIG. 10 is a partial top view of a region E on the display panel shown in FIG. 9;
FIG. 11 is a diagram of a structure of another display panel according to an embodiment of this application;
FIG. 12 is a partial top view of a region E on the display panel shown in FIG. 11;
FIG. 13 is a diagram of a structure of another display panel according to an embodiment of this application;
FIG. 14 is a diagram of a structure of another display panel according to an embodiment of this application;
FIG. 15 is a diagram of a structure of another display panel according to an embodiment of this application;
FIG. 16 is a diagram of a structure of another display panel according to an embodiment of this application;
FIG. 17 is a diagram of a structure of another display panel according to an embodiment of this application;
FIG. 18 is a diagram of a structure of another display panel according to an embodiment of this application;
FIG. 19 is a diagram of a structure of another display panel according to an embodiment of this application;
FIG. 20 is a diagram of a structure of another display panel according to an embodiment of this application;
FIG. 21 is a diagram of a structure of another display panel according to an embodiment of this application;
FIG. 22 is a diagram of a structure of another display panel according to an embodiment of this application;
FIG. 23 is a diagram of a structure of another display panel according to an embodiment of this application;
FIG. 24 is a diagram of a structure of another display panel according to an embodiment of this application;
FIG. 25 is a diagram of a structure of another display panel according to an embodiment of this application;
FIG. 26 is a diagram of a structure of another display panel according to an embodiment of this application;
FIG. 27 is a flowchart of a display panel preparation method according to an embodiment of this application;
FIG. 28a to FIG. 28f are step diagrams of a display panel preparation method according to an embodiment of this application;
FIG. 29a and FIG. 29b are step diagrams of a method for preparing a light emission function layer and a cathode layer according to an embodiment of this application; and
FIG. 30a to FIG. 30c are step diagrams of another method for preparing a light emission function layer and a cathode layer according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

In the descriptions of this application, unless otherwise specified, "a plurality of" means two or more. "At least one of the following items (pieces)" or a similar expression thereof refers to any combination of these items, including any combination of singular items (pieces) or plural items (pieces). For example, at least one item (piece) of a, b, or c may indicate: a, b, c, a and b, a and c, b and c, or a, b, and c, where a, b, and c may be singular or plural.

"And/or" describes an association relationship between associated objects, and represents that three relationships may exist. For example, A and/or B may represent the following cases: A exists alone, both A and B exist, and B exists alone, where A and B may be singular or plural. A character "/" usually indicates an "or" relationship between the associated objects.

In addition, to clearly describe the technical solutions in the embodiments of this application, terms such as "first" and "second" are used in embodiments of this application to distinguish between same items or similar items that have a basically same function and purpose. A person skilled in the art may understand that the terms such as "first" and "second" do not limit a quantity or an execution sequence, and the terms such as "first" and "second" do not indicate a definite difference. In addition, in embodiments of this application, words such as "example" or "for example" are used to represent giving an example, an illustration, or a description. Any embodiment or design scheme described as an "example" or "for example" in embodiments of this application should not be explained as being more preferred or having more advantages than another embodiment or design scheme. Exactly, use of the word such as "example" or "for example" is intended to present a related concept in a specific manner for ease of understanding.

In embodiments of this application, "up", "down", "left", and "right" are not limited to orientations of schematically placed components in relative accompanying drawings. It should be understood that these orientation terms may be relative concepts. The orientation terms are used for relative description and clarification, and may vary correspondingly based on a change in an orientation in which the component is placed in the accompanying drawings. In the accompanying drawings, for clarity, thicknesses of layers and regions are exaggerated, and a size proportion relationship between parts in the figures does not reflect an actual size proportion relationship.

This application describes example implementations are described with reference to sectional views and/or plane diagrams that are used as idealized example accompanying drawings. In the accompanying drawings, for clarity, thicknesses of layers and regions are increased. Thus, a change in a shape in the accompanying drawings due to, for example, manufacturing techniques and/or tolerances may be envisaged. Therefore, the example implementations should not be construed as being limited to the shapes of the regions shown in this application, but include shape deviations caused by, for example, manufacturing. For example, an etching region shown as a rectangle typically has a bending characteristic. Therefore, the regions shown in the accompanying drawings are essentially examples, and their shapes are not intended to show actual shapes of regions of a device, and are not intended to limit a scope of the example implementations.

In addition, an architecture and a scenario described in embodiments of this application are intended to describe the technical solutions in embodiments of this application more clearly, and do not constitute a limitation on the technical solutions provided in embodiments of this application. A person of ordinary skill in the art may know that: With the evolution of the architecture and the emergence of new scenarios, the technical solutions provided in embodiments of this application are also applicable to similar technical problems.

Some embodiments of this application provide an electronic device. The electronic device is, for example, a consumer electronic product, a home electronic product, an in-vehicle electronic product, or a financial terminal product. The consumer electronic product may be a mobile phone (mobile phone), a pad (pad), a desktop computer, a laptop computer, a handheld computer, a notebook computer, a personal computer (personal computer, PC), a netbook, a cellular phone, a personal digital assistant (PDA), an augmented reality (AR) device, a virtual reality (virtual reality, VR) device, an artificial intelligence (artificial intelligence, AI) device, an intelligent wearable device (for example, a smartwatch and a smart band), and the like. A specific type of the electronic device is not specially limited in embodiments of this application. The home electronic product may be an intelligent lock, a television, a remote control, a refrigerator, a small household charging appliance (for example, a soy milk maker or a robot vacuum), or the like. The in-vehicle electronic product may be an in-vehicle navigator, an in-vehicle DVD, or the like. The financial terminal product may be an ATM, a self-service terminal, or the like.

A specific form of the electronic device is not specially limited in embodiments of this application. For ease of description, the following uses an example in which the electronic device is a mobile phone for description.

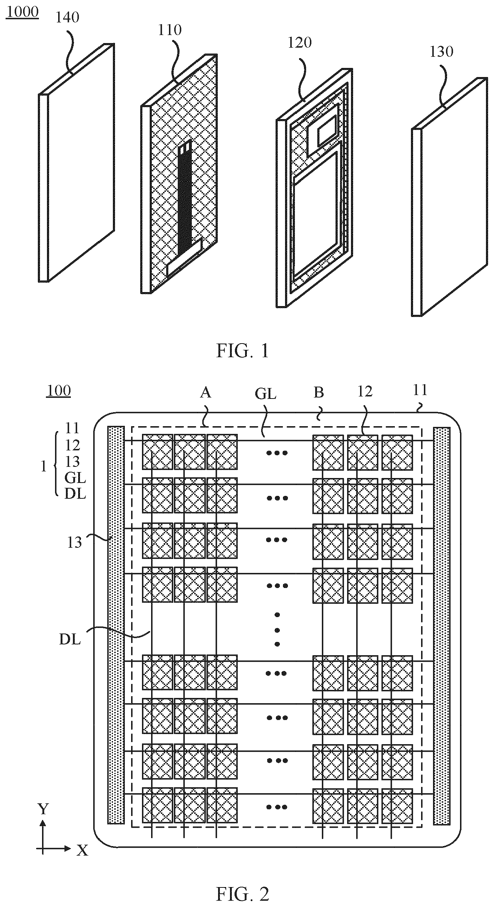

In some embodiments provided in this application, as shown in FIG. 1, an electronic device 1000 mainly includes a display module 110, a middle frame 120, a housing 130, and a cover 140.

The display module 110 and the middle frame 120 are disposed in the housing 130, the middle frame 120 is located between the display module 110 and the housing 130, and a surface that is of the middle frame 120 and that is away from the display module 110 (that is, a surface that faces the housing 130) is configured to install internal components such as a battery, a circuit board, a camera (camera), and an antenna.

The cover 140 is located on a side that is of the display module 110 and that is away from the middle frame 120. The cover 140 may be, for example, cover glass (cover glass, CG), and the cover glass may have specific toughness.

The display module 110 has a light emission side that can display a picture and a backlight side that is disposed opposite to the light emission side. The middle frame 120 is disposed on the backlight side of the display module 110, and the cover 140 is disposed on the light emission side of the display module 110.

In some examples, the display module 110 includes a display panel (display panel, DP). For example, the display panel includes but is not limited to an organic light emitting diode (organic light emitting diode, OLED) display panel, a quantum dot light emitting diode (quantum dot light emitting diode, QLED) display panel, or the like.

The following describes some embodiments of this application by using an example in which the display panel is an OLED display panel. The OLED display panel is, for example, an AMOLED display panel.

It may be understood that, as an application scale of the AMOLED display panel increases, costs (for example, shared costs of a single AMOLED display panel) of the AMOLED display panel are gradually reduced. Therefore, a display product in which the AMOLED display panel is used gradually develops from a small-sized display product (for example, a band, a watch, or a mobile phone) to a medium- and large-sized display product (for example, a tablet computer or a PC).

Some embodiments of this application further provide a display panel. The display panel may be used in the display module 110 in the electronic device 1000, and is electrically connected to an integrated circuit. The display panel is, for example, used in a medium- and large-sized display product.

FIG. 2 to FIG. 4 each show a top-view structure of a display panel 100. The display panel 100 has a display region A and a peripheral region B located on a periphery of the display region A. For example, the peripheral region B may be disposed around the display region A. Certainly, the peripheral region B may alternatively be located on one or more sides of the display region A.

In some embodiments, as shown in FIG. 2 to FIG. 5, the display panel 100 includes a backplane (Backplane) 1.

In some examples, as shown in FIG. 2 to FIG. 5, the backplane 1 includes a substrate 11.

The substrate 11 has a plurality of types, and may be selectively disposed based on an actual requirement.

For example, the substrate 11 may be a rigid substrate. A material of the rigid substrate may include, for example, glass, quartz, or plastic.

For example, the substrate 11 may be a flexible substrate. A material of the flexible substrate may include, for example, PET (Polyethylene terephthalate), PEN (Polyethylene naphthalate two formic acid glycol ester), PI (Polyimide), or the like.

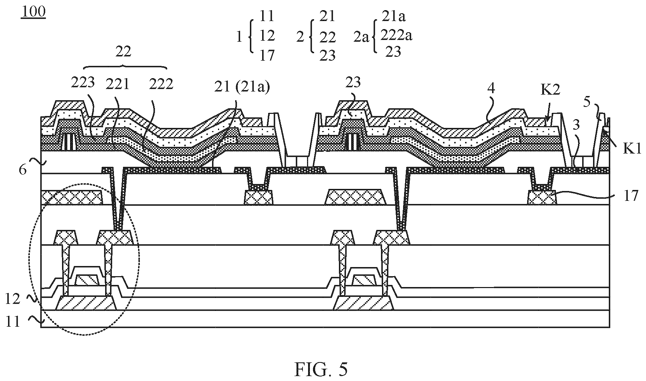

In some examples, as shown in FIG. 5, the backplane 1 further includes a plurality of pixel drive circuits 12 disposed on the substrate 11. As shown in FIG. 2 to FIG. 4, the plurality of pixel drive circuits 12 are, for example, located in the display region A and arranged in an array shape. The pixel drive circuit 12 includes but is not limited to an LTPS drive circuit.

The pixel drive circuit 12 has a plurality of structures, and may be selectively disposed based on an actual requirement. For example, the structure of the pixel drive circuit 12 may include structures such as "3T1C", "4T1C", "6T1C", "7T1C", "6T2C", "7T2C", or "8T2C". "T" represents a transistor, a number before "T" represents a quantity of transistors, "C" represents a storage capacitor, and a number before "C" represents a quantity of storage capacitors.

In some examples, as shown in FIG. 2 to FIG. 4, the backplane 1 further includes a plurality of gate lines GLs and a plurality of data lines DLs that are disposed on the substrate 11. The plurality of gate lines GLs are located in the display region A, extend in a first direction X, and are sequentially arranged in a second direction Y. The plurality of data lines DLs are located in the display region A, extend in the second direction Y, and are sequentially arranged in the first direction X.

For example, the first direction X intersects with the second direction Y. For example, an included angle between the first direction X and the second direction Y is 90°, 89°, 88°, 85°, or the like.

Optionally, for example, the first direction X is perpendicular to the second direction Y.

Each gate line GL is electrically connected to, for example, one row of pixel drive circuits 12, and the gate line GL is configured to transmit a gate signal to the pixel drive circuits 12 electrically connected to the gate line GL. Each data line DL is electrically connected to, for example, one column of pixel drive circuits 12, and the data line DL is configured to transmit a data signal to the pixel drive circuits 12 electrically connected to the data line DL.

In some examples, as shown in FIG. 2 to FIG. 4, the backplane 1 further includes first scanning circuits 13 disposed on the substrate 11. The first scanning circuits 13 are located in the peripheral region B, and are electrically connected to the plurality of gate lines GLs.

The first scanning circuit 13 includes a plurality of first shift registers, and each first shift register is electrically connected to, for example, at least one gate line GL. The first shift register is configured to generate a gate signal, and transmit the gate signal to the gate line GL electrically connected to the first shift register.

For example, the first scanning circuits 13 may be located on a side of the display region A. For another example, as shown in FIG. 2 to FIG. 4, the first scanning circuits 13 may be located on two opposite sides of the display region A, to form dual-side driving.

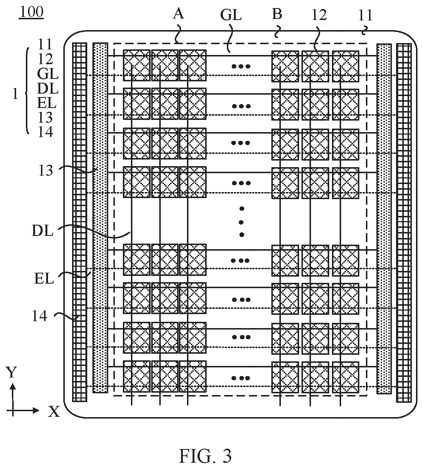

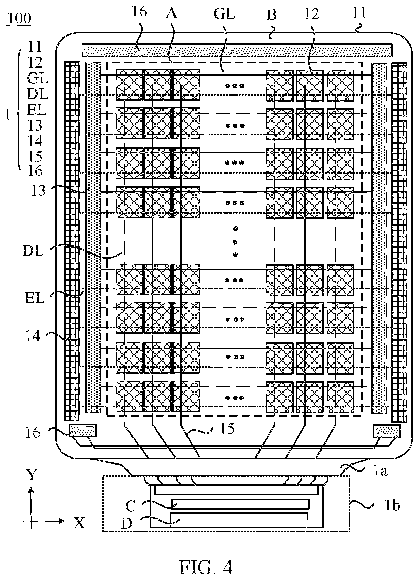

Optionally, based on the structure of the pixel drive circuit 12, as shown in FIG. 3 and FIG. 4, the backplane 1 further includes a plurality of enabling signal lines ELs disposed on the substrate 11. The plurality of enabling signal lines ELs are located in the display region A, extend in the first direction X, and are sequentially arranged in the second direction Y.

Each enabling signal line EL is electrically connected to, for example, one row of pixel drive circuits 12, and the enabling signal line EL is configured to transmit an enabling signal to the pixel drive circuits 12 electrically connected to the enabling signal line EL.

Correspondingly, in some examples, as shown in FIG. 3 and FIG. 4, the backplane 1 further includes second scanning circuits 14 disposed on the substrate 11. The second scanning circuits 14 are located in the peripheral region B, and are electrically connected to the plurality of enabling signal lines ELs.

The second scanning circuit 14 includes a plurality of second shift registers, and each second shift register is electrically connected to, for example, at least one enabling signal line EL. The second shift register is configured to generate an enabling signal, and transmit the enabling signal to the enabling signal line EL electrically connected to the second shift register.

For example, the second scanning circuits 14 may be located on a side of the display region A. For another example, as shown in FIG. 3 and FIG. 4, the second scanning circuits 14 may be located on two opposite sides of the display region A, to form dual-side driving.

In some examples, as shown in FIG. 4, the backplane 1 may be divided into a main display part, a bending (Bending) part 1a, and a circuit connection part 1b that are sequentially disposed in the second direction Y.

The main display part is configured to display a picture, and the main display part has a light emission side for displaying the picture and a backlight side that is disposed opposite to the light emission side. The circuit connection part 1b is configured to connect various circuit structures. For example, the circuit connection part 1b has an integrated circuit binding region C and an FOF connection region D. The circuit binding region C is bound to an integrated circuit (integrated circuit, IC), and the FOF connection region D is bound to a flexible circuit board.

The bending part 1a can be bent, so that the circuit connection part 1b is bent to the backlight side of the main display part. This helps reduce a frame size and implement a narrow frame design.

For example, as shown in FIG. 4, the backplane 1 further includes a plurality of fanout (Fanout) lines 15 and a plurality of electro-static discharge (ESD) structures 16 disposed on the substrate 11. The plurality of fanout lines 15 and the plurality of electro-static discharge (ESD) structures 16 are all located in the peripheral region B, and the plurality of fanout lines 15 are electrically connected to the plurality of data lines DLs in a one-to-one correspondence.

In some embodiments, as shown in FIG. 5, the display panel 100 further includes a light emission device layer 2 located on the backplane 1. In the figure, one transistor represents one pixel drive circuit 12.

In some examples, the light emission device layer includes a plurality of light emission devices 2a, and the plurality of light emission devices 2a are arranged, for example, in an array shape. The light emission device 2a is, for example, an OLED.

The pixel drive circuit 12 is electrically connected to the light emission device. The pixel drive circuit 12 and the light emission device have a plurality of electrical connection relationships, and may be specifically selected and disposed based on an actual requirement. This is not limited in this disclosure.

For example, the pixel drive circuits 12 may be electrically connected to the light emission devices 2a in a one-to-one correspondence. For another example, one pixel drive circuit 12 may be electrically connected to a plurality of light emission devices 2a. For another example, a plurality of pixel drive circuits 12 may be electrically connected to one light emission device 2a.

The following describes the structure of the display panel 100 by using an example in which the pixel drive circuits 12 are electrically connected to the light emission devices 2a in a one-to-one correspondence.

In some examples, as shown in FIG. 5, the light emission device layer 2 includes an anode layer 21 located on the backplane 1, and a light emission function layer 22 and a cathode layer 23 that are located on the anode layer 21 and that are sequentially stacked.

The anode layer 21 includes anodes 21a, there are a plurality of anodes 21a, the plurality of anodes 21a are disposed independently of each other, and there is a gap between any two adjacent anodes 21a. For example, the plurality of anodes 21a are arranged in an array shape. For example, the cathode layer 23 is disposed as an entire layer. In this application, for example, the cathode layer 23 is formed by using an entire-plane evaporation process.

The light emission function layer 22 includes a light emission layer (emission layer, EML) 222, and the light emission layer 222 is configured to emit light. There are a plurality of light emission layers 222, the plurality of light emission layers 222 are disposed independently of each other, and there is a gap between any two adjacent light emission layers 222. For example, the light emission layers 222 and the anodes 21a are disposed in a one-to-one correspondence. Optionally, the light emission function layer 22 further includes a first common layer (common layer) 221 located between the anodes 21a and the light emission layers 222, and a second common layer 223 located between the light emission layers 222 and the anode layer 21, where the first common layer 221 includes but is not limited to a hole injection layer (hole injection layer, HIL) and/or a hole transportation layer (hole transportation layer, HTL), and the second common layer 223 includes but is not limited to an electron injection layer and/or an electron transportation layer (electron transportation layer, ETL). The first common layer 221 and the second common layer 223 are, for example, disposed as entire layers.

It may be understood that each anode 21a, a light emission layer 222 corresponding to the anode 21a, and parts that are of the first common layer 221, the second common layer 223, and the cathode layer 23 and that are directly opposite to the anode 21a form a light emission device 2a.

For example, the anodes 21a are electrically connected to the pixel drive circuits 12 in a one-to-one correspondence, to receive a drive signal from the pixel drive circuits 12, the cathode layer 23 receives a reference voltage signal (or referred to as a cathode power supply signal) ELVSS, and the light emission layer 222 emits light under a joint action of the drive signal and the reference voltage signal ELVSS. The plurality of light emission devices 2a cooperate with each other, so that the display panel 100 can implement picture display.

The light emission device 2a is a top-emission light emission device. Therefore, the anode 21a is an electrode that is basically non-transparent and has high reflectivity, and the cathode layer 23 is an electrode that is light-transmitting or semi-transparent. For example, a material of the cathode layer 23 includes but is not limited to magnesium (Mg), silver (Ag), aluminum (Al), magnesium-silver alloy, indium tin oxide (ITO), and the like.

It should be noted that the cathode layer 23 prepared by using the ITO has high transmittance, but a resistance of the cathode layer 23 is accordingly large. The cathode layer 23 prepared by using a metal material (namely, Mg, Ag, Al, or the like) has small thickness, to ensure transmittance of the cathode layer 23. Consequently, the resistance of the cathode layer 23 is increased. Voltage drops (IR Drops) in different regions of the cathode layer 23 are different, and therefore voltage values of reference voltage signals ELVSS received by different light emission devices 2a are different. Consequently, display luminance uniformity of the display panel 100 is poor.

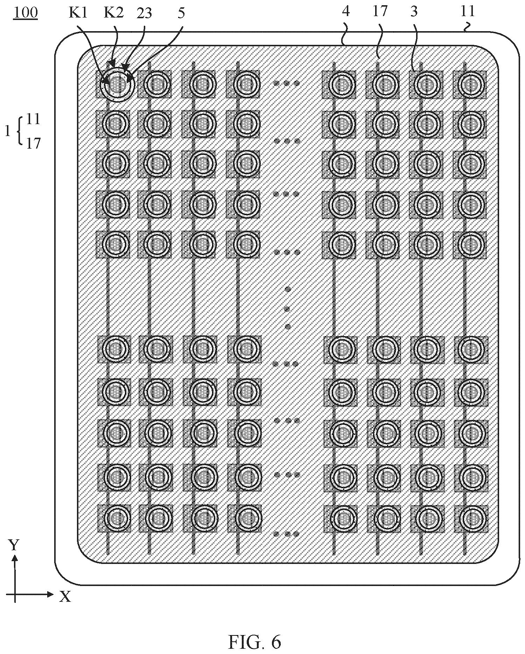

Based on this, in some embodiments of this application, as shown in FIG. 5 and FIG. 6, the backplane 1 further includes an auxiliary signal line 17, and the display panel 100 further includes a transfer electrode 3, a cathode suppression layer 4, and an auxiliary cathode 5. A material of the auxiliary cathode 5 may be the same as or different from the material of the cathode layer 23. There are a plurality of auxiliary signal lines 17, transfer electrodes 3, and auxiliary cathodes 5.

In some examples, as shown in FIG. 5, the transfer electrode 3 is disposed on a same layer as the anode layer 21, and is electrically connected to the auxiliary signal line 17. For example, the transfer electrode 3 and any anode 21a in the anode layer 21 are disposed independently of each other, and are not connected.

It may be understood that the "same layer" mentioned in this disclosure refers to a layer structure formed by using a same film forming process to form a film layer of a specific pattern, and then using a same mask through a patterning process. According to different specific patterns, one patterning process may include a plurality of times of exposure, development, or etching processes. Specific patterns in the formed layer structure may be continuous or discontinuous, and these specific patterns may be at different heights or have different thickness. In this way, the transfer electrode 3 and the anode layer 21 can be simultaneously prepared and formed in one patterning process. This helps simplify a preparation process of the display panel 100.

Herein, because the transfer electrode 3 and the anode layer 21 are disposed on the same layer, the light emission function layer 22 and the cathode layer 23 are also located on the transfer electrode 3.

In some examples, as shown in FIG. 5 and FIG. 6, the light emission function layer 22 and the cathode layer 23 are provided with a first opening K1, and the first opening exposes a part of a surface of the transfer electrode 3. In other words, the first opening K1 penetrates through the light emission function layer 22 and the cathode layer 23 to the transfer electrode 3. Certainly, when there is another film layer (for example, a pixel definition layer 6 mentioned in the following) between the light emission function layer 22 and the transfer electrode 3, the first opening K1 further penetrates through the another film layer to expose the transfer electrode 3.

In some examples, as shown in FIG. 5 and FIG. 6, at least a part of the cathode suppression layer 4 is located on the cathode layer 23, the cathode suppression layer 4 is provided with a second opening K2, and the second opening K2 at least partially overlaps the first opening K1, and exposes a part of the surface of the transfer electrode 3. In other words, the second opening K2 is connected to the first opening K1, and the second opening K2 exposes the part of the surface of the transfer electrode 3 through a part that is connected to the first opening K1.

The "at least partially overlaps" includes: The second opening K2 approximately coincides with the first opening K1, and the two are completely connected. In this case, the cathode suppression layer 4 is entirely located on the cathode layer 23, and the part that is of the surface of the transfer electrode 3 and that is exposed by the first opening K1 is completely exposed by the second opening K2. Alternatively, the "at least partially overlaps" includes: The second opening K2 partially overlaps the first opening K1, and the second opening K2 and the first opening K1 are connected through an overlapped part. In this case, a part of the cathode suppression layer 4 is located on the cathode layer 23, the other part covers a part of a side wall of the first opening K1, and in the part that is of the surface of the transfer electrode 3 and that is exposed by the first opening K1, a part is blocked by the cathode suppression layer 4, and the other part is exposed by the second opening K2; or the cathode suppression layer 4 is entirely located on the cathode layer 23, and the second opening K2 exposes the first opening K1, and exposes the cathode layer 23.

In some examples, as shown in FIG. 5 and FIG. 6, at least a part of the auxiliary cathode 5 is located in the first opening K1, the auxiliary cathode 5 is connected to the cathode layer 23 and the transfer electrode 3, and the auxiliary cathode 5 does not overlap the cathode suppression layer 4.

Herein, a material of the cathode suppression layer 4 and a material of the auxiliary cathode 5 have small adhesive, or even repels each other. In a process of preparing and forming the auxiliary cathode 5, the material of the auxiliary cathode 5 is formed at a location other than the cathode suppression layer 4, and basically there is no material of the auxiliary cathode 5 on a surface of the cathode suppression layer 4. Therefore, the auxiliary cathode 5 does not overlap the cathode suppression layer 4. In this way, evaporation on a large quantity of materials of the auxiliary cathode 5 can be avoided on the cathode layer 23, increase of thickness of the cathode layer 23 is avoided, and impact on transmittance of the cathode layer 23 is avoided.

For example, the material of the auxiliary cathode 5 includes Mg, and the material of the cathode suppression layer 4 includes at least one of BAlq (Bis(2-methyl-8-quinolinolate)-4-(phenylphenolato) aluminum), TAZ (3-(Biphenyl-4-yl)-5-(4-tert-butylphenyl)-4-phenyl-4H-1,2,4-triazole), and OTI (indium oxide).

The "at least a part" includes: The auxiliary cathode 5 is entirely located in the first opening K1; or a part of the auxiliary cathode 5 is located in the first opening K1, and the other part is located outside the first opening K1. A manner of disposing the auxiliary cathode 5 and the first opening K1 may be determined based on a location relationship between the first opening K1 and the second opening K2.

The auxiliary cathode 5 is not only in contact with the cathode layer 23, but also in contact with the exposed part of the surface of the transfer electrode 3, so that the cathode layer 23 can be electrically connected to the transfer electrode 3 through the auxiliary cathode 5. Because the transfer electrode 3 is electrically connected to the auxiliary signal line 17, it means that the cathode layer 23 may be transferred through the auxiliary cathode 5 and the transfer electrode 3, to implement parallel connection with the auxiliary signal line 17. The cathode layer 23 and the auxiliary signal line 17 are disposed in parallel, so that a resistance of the cathode layer 23 can be effectively reduced, voltage drops in different regions of the cathode layer 23 tend to be consistent, a difference between voltage drops in different regions of the cathode layer 23 is reduced, voltage uniformity and stability of reference voltage signals ELVSS received by different light emission devices 2a are improved, and display brightness uniformity of the display panel 100 is improved.

Therefore, according to the display panel 100 provided in some embodiments of this application, the auxiliary signal line 17 is disposed on the backplane 1, the transfer electrode 3 that is on the same layer as the anode layer 21 and that is electrically connected to the auxiliary signal line 17 is disposed, the light emission function layer 22 and the cathode layer 23 are provided with the first opening K1 that exposes the part of the surface of the transfer electrode 3, the cathode suppression layer 4 is provided with the second opening K2 that at least partially overlaps the first opening K1, and the auxiliary cathode 5 that is at least partially located in the first opening K1 is disposed through the second opening K2, so that the auxiliary cathode 5 may be used to connect the cathode layer 23 to the transfer electrode 3, that is, to form a structure in which the auxiliary signal line 17 is lapped on the cathode layer 23 at a plurality of points, to implement an electrical connection between the cathode layer 23 and the auxiliary signal line 17 (the cathode layer and the auxiliary signal line are connected in parallel). In this way, the resistance of the cathode layer 23 may be reduced by using the auxiliary signal line 17, and the difference between voltage drops in different regions of the cathode layer 23 may be reduced, that is, the voltage drops in different regions of the cathode layer 23 tend to be consistent, so that the voltages of the cathode layer 23 in the entire display region A tend to be consistent. This helps improve the uniformity and stability of the voltage values of the reference voltage signals ELVSS received by different light emission devices 2a, and improve the uniformity of display brightness of the display panel 100.

In some embodiments, the cathode suppression layer 4 is a light-transmitting film layer.

In this way, the cathode suppression layer 4 can have high light transmittance, to avoid affecting light emission efficiency of the display panel 100.

It should be noted that, because the auxiliary cathode 5 is in contact with the cathode layer 23, in this application, the auxiliary cathode 5 may be further used to adjust the resistance of the cathode layer 23. Whether the thickness of the auxiliary cathode 5 is less than, equal to, or greater than the thickness of the cathode layer 23 may be specifically determined based on a requirement. The "thickness" mentioned in this specification is, for example, average thickness.

In some embodiments, the thickness of the auxiliary cathode 5 is greater than or equal to the thickness of the cathode layer 23.

For example, thickness of a part that is of the auxiliary cathode 5 and that is in contact with the transfer electrode 3 is greater than or equal to the thickness of the cathode layer 23. In this way, lap impedance between the auxiliary cathode 5 and the transfer electrode 3 may be reduced (for example, reduced to minimum).

When the thickness of the auxiliary cathode 5 is equal to the thickness of the cathode layer 23, the resistance of the cathode layer 23 is basically not affected by the auxiliary cathode 5. Therefore, increase of the resistance of the cathode layer 23 can be avoided. When the thickness of the auxiliary cathode 5 is greater than the thickness of the cathode layer 23, the resistance of the cathode layer 23 decreases.

Based on this, in embodiments of this application, the thickness of the auxiliary cathode 5 can be flexibly adjusted, so that not only the lap impedance between the auxiliary cathode 5 and the transfer electrode 3 can be reduced, and the resistance of the cathode layer 23 can be reduced by using the auxiliary cathode 5, but also the difference between the voltage drops in different regions of the cathode layer 23 can be further reduced through cooperation with the auxiliary signal line 17. This further improves the display brightness uniformity of the display panel 100.

The following schematically describes a manner of disposing the auxiliary cathode 5 and the first opening K1, and a location relationship between the first opening K1 and the second opening K2. The manner of disposing the auxiliary cathode 5 and the first opening K1 and the location relationship between the first opening K1 and the second opening K2 are not limited to examples in the following.

It should be noted that, based on preparation processes of the first opening K1 and the cathode suppression layer 4, both a side wall of the first opening K1 and a side wall of the second opening K2 are at an acute angle with a plane on which the backplane is located. Correspondingly, the side wall of the first opening K1 is disposed obliquely, and an area of an end that is of the first opening K1 and that is away from the backplane 1 is greater than an area of an end that is of the first opening K1 and that is close to the backplane 1. The side wall of the second opening K2 is disposed obliquely, and an area of an end that is of the second opening K2 and that is away from the backplane 1 is greater than an area of an end that is of the second opening K2 and that is close to the backplane 1.

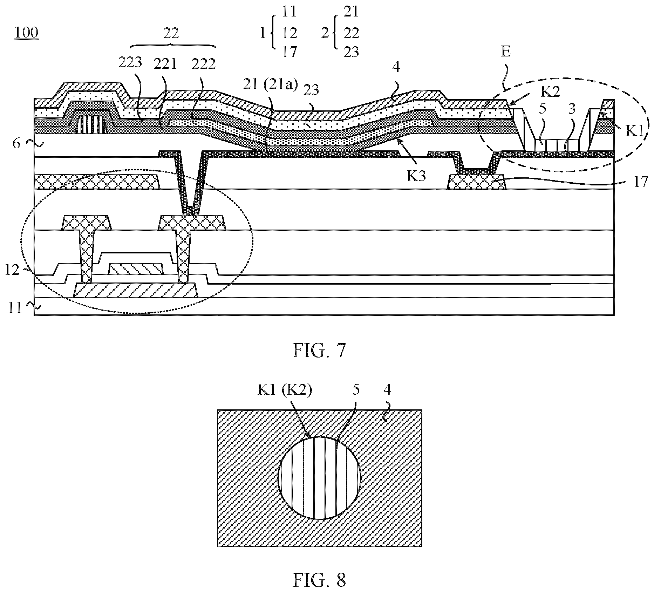

In some embodiments, as shown in FIG. 7 and FIG. 8, the first opening K1 approximately coincides with the second opening K2. Based on structures of the first opening K1 and the second opening K2, an outer boundary of an orthographic projection of the first opening K1 on the backplane 1 coincides with an inner boundary of an orthographic projection of the second opening K2 on the backplane 1.

In other words, a shape of the first opening K1 is the same as a shape of the second opening K2, and an area of an end that is of the first opening K1 and that is away from the backplane 1 is equal to an area of an end that is of the second opening K2 and that is close to the backplane 1. A solid circle to which an arrow points in FIG. 8 represents both the first opening K1 and the second opening K2, and the first opening K1 is completely connected to the second opening K2.

In this example, the cathode suppression layer 4 is located on the cathode layer 23. A shape of the cathode suppression layer 4 is the same as or approximately the same as a shape of the cathode layer 23, and flatness of the cathode suppression layer 4 is good.

For example, as shown in FIG. 7, the auxiliary cathode 5 is located in the first opening K1, and abuts against an edge of the cathode layer 23. An area of an orthographic projection of the auxiliary cathode 5 on the backplane 1 is equal to or approximately equal to an area enclosed by an outer boundary of an orthographic projection of the first opening K1 on the backplane 1.

Because the material of the cathode suppression layer 4 and the material of the auxiliary cathode 5 has small adhesive force, or even repels each other, in a process of preparing and forming the auxiliary cathode 5, the material of the auxiliary cathode 5 passes through the second opening K2 and is formed in the first opening K1, and is attached to the exposed surface of the transfer electrode 3 and the side wall of the first opening K1, but is basically not formed on a side wall of the second opening K2, that is, basically, the material of the auxiliary cathode 5 is not in contact with the cathode suppression layer 4. A part that is of the cathode layer 23 and that surrounds the first opening K1 forms a part of the side wall of the first opening K1, and a part of the auxiliary cathode 5 is attached to the side wall of the first opening K1, that is, the auxiliary cathode 5 abuts against the part of that is of the cathode layer 23 and that surrounds the first opening K1.

In the foregoing disposing manner, it can be ensured that the auxiliary cathode 5 is located in the first opening K1, and is basically not located in the second opening K2 or basically is not lapped on the cathode suppression layer 4, to avoid protruding of the auxiliary cathode 5 relative to the cathode suppression layer 4. This helps improve surface flatness of the display panel 100 while an electrical connection between the cathode layer 23 and the transfer electrode 3 is implemented.

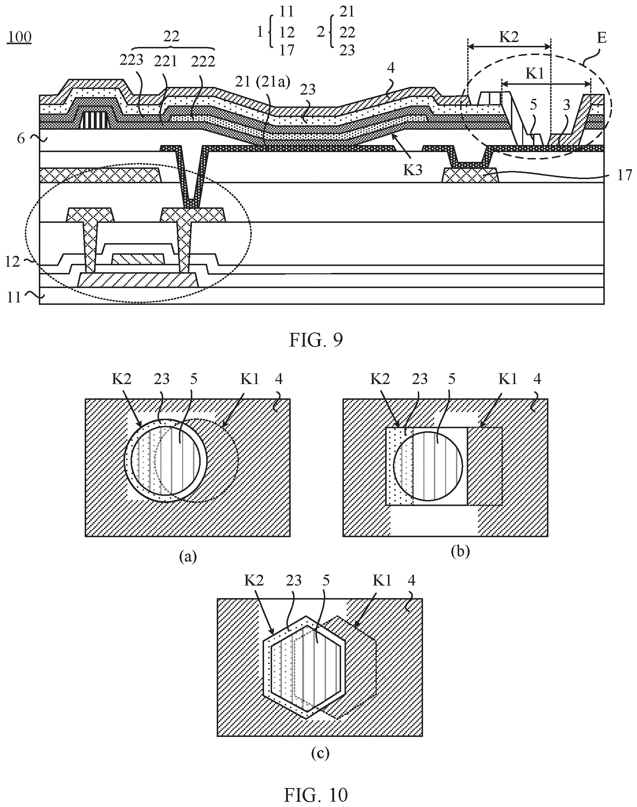

In some other embodiments, as shown in FIG. 9 and FIG. 10, the second opening K2 partially overlaps the first opening K1. Based on structures of the first opening K1 and the second opening K2, an outer boundary of an orthographic projection of the first opening K1 on the backplane 1 intersects with an inner boundary of an orthographic projection of the second opening K2 on the backplane 1.

A shape of the first opening K1 may be the same as or different from a shape of the second opening K2. A structure shown in FIG. 10 shows a case in which the shape of the first opening K1 is the same as the shape of the second opening K2. A dashed circle to which an arrow points in (a) in FIG. 10 and a dashed box to which an arrow points in (b) and (c) in FIG. 10 represent the first opening K1, and a solid circle to which an arrow points in (a) in FIG. 10 and a solid box to which an arrow points in (b) and (c) in FIG. 10 represents the second opening K2. In FIG. 10, a white part where the dashed circle overlaps the solid circle in (a) and a white part where the dashed box overlaps the solid box overlap in (b) and (c) are overlapped parts of the first opening K1 and the second opening K2, through which the first opening K1 and the second opening K2 are connected.

In this example, a part of the cathode suppression layer 4 is located on the cathode layer 23, and the other part of the cathode suppression layer 4 covers a part of the side wall of the first opening K1.

For example, the cathode suppression layer 4 is formed later than the first opening K1. Therefore, a part of the cathode suppression layer 4 is located on the cathode layer 23, exposing a part of the cathode layer 23, for example, an exposed part of the cathode layer 23 in the solid circle as shown in (a) in FIG. 10, and an exposed part of the cathode layer 23 in the solid boxes in (b) and (c) in FIG. 10. The other part of the cathode suppression layer 4 is located in the first opening K1, and covers a part of the side wall of the first opening K1, or covers a part of the side wall of the first opening K1 and a part of the surface of the transfer electrode 3. As shown in FIG. 9, the cathode suppression layer 4 covers the part of the side wall of the first opening K1 and the part of the surface of the transfer electrode 3, and as shown in FIG. 10, the cathode suppression layer 4 in (a) extends into a region enclosed by the dashed circle, and the cathode suppression layer 4 in (b) and (c) extends into a region enclosed by the dashed box.

It may be understood that the cathode suppression layer 4 is of an entire-layer structure. Because the part of the cathode suppression layer 4 is located in the first opening K1, the entire cathode suppression layer 4 has a recess, and the part that is of the cathode suppression layer 4 and that surrounds the second opening K2 is no longer located on a same plane. Correspondingly, in comparison with the first opening K1, the second opening K2 is an irregular opening, and the second opening K2 and the first opening K1 share a part.

Because the material of the cathode suppression layer 4 and the material of the auxiliary cathode 5 has small adhesive force, or even repels each other, in the process of preparing and forming the auxiliary cathode 5, the material of the auxiliary cathode 5 is not only formed in the first opening K1, and is in contact with the transfer electrode 3, but also attached to a part that is of the side wall of the first opening K1 and that is not covered by the cathode suppression layer 4, and is further formed on the part that is of the cathode layer 23 and that is exposed by the second opening K2, to be in contact with the cathode layer 23. The auxiliary cathode 5 formed in this manner is, for example, in a shape of "Z" shown in FIG. 9. A part of the auxiliary cathode 5 is located in the first opening K1 and is electrically connected to the transfer electrode 3. The other part of the auxiliary cathode 5 is lapped on the cathode layer 23 along the side wall of the first opening K1, and is electrically connected to the cathode layer 23.

The foregoing disposing manner is used to help increase a contact area between the auxiliary cathode 5 and the cathode layer 23. In this way, while an electrical connection between the cathode layer 23 and the transfer electrode 3 is implemented, structural stability between the auxiliary cathode 5 and the cathode layer 23 can be enhanced, and reliability of the electrical connection between the auxiliary cathode 5 and the cathode layer 23 is improved.

In some examples, when a part of the cathode suppression layer 4 is located on the cathode layer 23, the other part of the cathode suppression layer 4 covers a part of the side wall of the first opening K1, and the outer boundary of the orthographic projection of the first opening K1 on the backplane 1 intersects with the inner boundary of the orthographic projection of the second opening K2 on the backplane 1, the part that is of the auxiliary cathode 5 and that is lapped on the cathode layer 23 is in a "C" shape or a "-" shape.

It can be understood that the shape of the part that is of the auxiliary cathode 5 and that is lapped on the cathode layer 23 is related to a shape and an area of the orthographic projection of the first opening K1 on the backplane 1 and a shape and an area of the orthographic projection of the second opening K2 on the backplane 1. The foregoing "C" shape or the "-" shape includes, for example, an irregular "C" shape or a "-" shape.

For example, as shown in (a) in FIG. 10, both the shape of the orthographic projection of the first opening K1 on the backplane 1 and the shape of the orthographic projection of the second opening K2 on the backplane 1 are circular, and the part that is of the auxiliary cathode 5 and that is lapped on the cathode layer 23 is in the "C" shape.

For example, as shown in (b) in FIG. 10, if the orthographic projection of the first opening K1 on the backplane 1 and the orthographic projection of the second opening K2 on the backplane 1 are both in a rectangular shape, and have an equal area, or if an area of the orthographic projection of the first opening K1 on the backplane 1 is greater than an area of the orthographic projection of the second opening K2 on the backplane 1, the part that is of the auxiliary cathode 5 and that is lapped on the cathode layer 23 is in the "-" shape. If an area of the orthographic projection of the first opening K1 on the backplane 1 is less than an area of the orthographic projection of the second opening K2 on the backplane 1, the part that is of the auxiliary cathode 5 and that is lapped on the cathode layer 23 is in the "C" shape.

For example, as shown in (c) in FIG. 10, if the orthographic projection of the first opening K1 on the backplane 1 and the orthographic projection of the second opening K2 on the backplane 1 are both in a hexagonal shape, and have an equal area, or if the area of the orthographic projection of the first opening K1 on the backplane 1 is less than the area of the orthographic projection of the second opening K2 on the backplane 1, the part that is of the auxiliary cathode 5 and that is lapped on the cathode layer 23 is in the "C" shape. If the area of the orthographic projection of the first opening K1 on the backplane 1 is greater than the area of the orthographic projection of the second opening K2 on the backplane 1, the part that is of the auxiliary cathode 5 and that is lapped on the cathode layer 23 is in the "C" shape or the "-" shape.

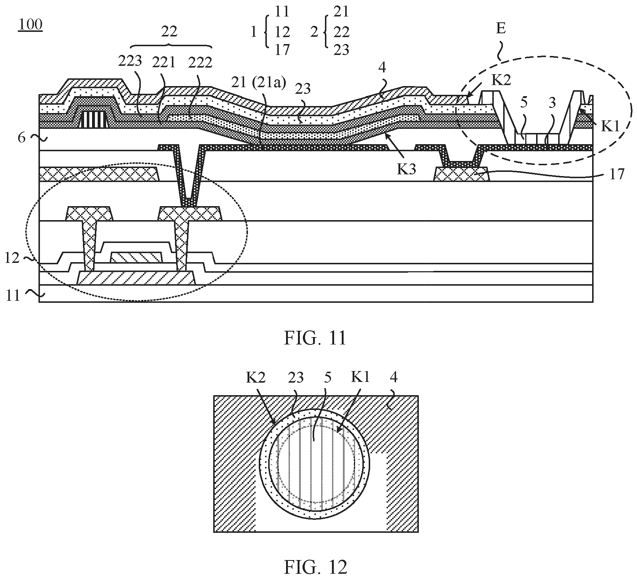

In some other embodiments, as shown in FIG. 11 and FIG. 12, the second opening K2 partially overlaps the first opening K1. Based on structures of the first opening K1 and the second opening K2, an outer boundary of the orthographic projection of the first opening K1 on the backplane 1 is located within an inner boundary range of the orthographic projection of the second opening K2 on the backplane 1.

The shape of the first opening K1 may be the same as or different from the shape of the second opening K2. An area of an end that is of the first opening K1 and that is away from the backplane 1 is less than an area of an end that is of the second opening K2 and that is close to the backplane 1. A spacing exists between the outer boundary of the orthographic projection of the first opening K1 on the backplane 1 and the inner boundary of the orthographic projection of the second opening K2 on the backplane 1, or a spacing and a coincided part exist between the outer boundary of the orthographic projection of the first opening K1 on the backplane 1 and the inner boundary of the orthographic projection of the second opening K2 on the backplane 1. A structure shown in FIG. 12 shows a case in which the shape of the first opening K1 is the same as the shape of the second opening K2. A dashed circle to which an arrow points in FIG. 12 represents the first opening K1, and a solid circle to which an arrow points in FIG. 12 represents the second opening K2. A spacing exists between the dashed circle and the solid circle, and the first opening K1 and the second opening K2 are connected through an overlapped part, that is, connected through a region enclosed by the dashed circle shown in FIG. 12.

In this example, the cathode suppression layer 4 is located on the cathode layer 23, and flatness of the cathode suppression layer 4 is good. Based on disposing manners the first opening K1 and the second opening K2, the second opening K2 exposes a part of the cathode layer 23. As shown in FIG. 12, a part of the cathode layer 23 is exposed in the solid circle.

Because the material of the cathode suppression layer 4 and the material of the auxiliary cathode 5 has small adhesive force, or even repels each other, in the process of preparing and forming the auxiliary cathode 5, the material of the auxiliary cathode 5 is not only formed in the first opening K1, and is in contact with the surface that is of the transfer electrode 3 and that is exposed by the first opening K1, but also attached to the side wall of the first opening K1, and is further formed on the part that is of the cathode layer 23 and that is exposed by the second opening K2, to be in contact with the cathode layer 23. A part of the auxiliary cathode 5 formed in this manner is located in the first opening K1 and is electrically connected to the transfer electrode 3. The other part of the auxiliary cathode 5 is lapped on the cathode layer 23 along the side wall of the first opening K1, and is electrically connected to the cathode layer 23.

The foregoing disposing manner is used to help increase the contact area between the auxiliary cathode 5 and the transfer electrode 3, and also helps increase the contact area between the auxiliary cathode 5 and the cathode layer 23. In this way, while the electrical connection between the cathode layer 23 and the transfer electrode 3 is implemented, structural stability between the auxiliary cathode 5 and the transfer electrode 3 can be enhanced, reliability of the electrical connection between the auxiliary cathode 5 and the transfer electrode 3 is improved, the structural stability between the auxiliary cathode 5 and the cathode layer 23 is enhanced, and the reliability of the electrical connection between the auxiliary cathode 5 and the cathode layer 23 is improved.

In some examples, as shown in FIG. 11 and FIG. 12, when the cathode suppression layer 4 is located on the cathode layer 23, and the outer boundary of the orthographic projection of the first opening K1 on the backplane 1 is located within the inner boundary range of the orthographic projection of the second opening K2 on the backplane 1, the area of the orthographic projection of the auxiliary cathode 5 on the backplane 1 is greater than an area of a graphic enclosed by the outer boundary of the orthographic projection of the first opening K1 on the backplane 1.

For example, the graphic enclosed by the outer boundary of the orthographic projection of the first opening K1 on the backplane 1 includes a circle, an ellipse, a polygon (for example, a triangle, a rectangle, a direction, a pentagon, or the like), and the like.

In this way, an overlapping area between the orthographic projection of the auxiliary cathode 5 on the backplane 1 and the orthographic projection of the cathode layer 23 on the backplane 1 can be increased, and an area of the part that is of the auxiliary cathode 5 and that is lapped on the cathode layer 23 is increased. This not only helps enhance the structural stability and the electrical connection reliability between the auxiliary cathode 5 and the cathode layer 23, but also enhances an impact degree of the auxiliary cathode 5 on a resistance of the cathode layer 23, so that the resistance of the cathode layer 23 is reduced by using the auxiliary cathode 5.

In some examples, as shown in FIG. 12, when the cathode suppression layer 4 is located on the cathode layer 23, and the outer boundary of the orthographic projection of the first opening K1 on the backplane 1 is located within the inner boundary range of the orthographic projection of the second opening K2 on the backplane 1, the part that is of the auxiliary cathode 5 and that is lapped on the cathode layer 23 is in ring shape.

For example, the ring includes but is not limited to a ring, a square ring, and the like, and may be determined based on the shape of the orthographic projection of the first opening K1 on the backplane 1 and the shape of the orthographic projection of the second opening K2 on the backplane 1.

It may be understood that the part that is of the auxiliary cathode 5 and that is lapped on the cathode layer 23 is in the ring shape, so that it can be ensured that the spacing exists between the outer boundary of the orthographic projection of the first opening K1 on the backplane 1 and the inner boundary of the orthographic projection of the second opening K2 on the backplane 1. In this way, the auxiliary cathode 5 is lapped on the part that is of the cathode layer 23 and that surrounds the first opening K1, to help enhance structural stability and electrical connection reliability between the auxiliary cathode 5 and the cathode layer 23.

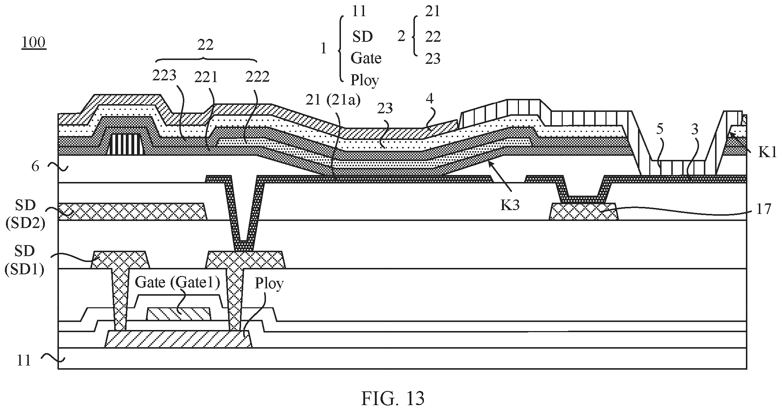

In some embodiments, as shown in FIG. 13, the display panel 100 further includes a pixel definition layer 6 located between the anode layer 21 and the light emission function layer 22. The anode layer 21 and the transfer electrode 3 are disposed on a same layer. Therefore, the pixel definition layer 6 is further located between the transfer electrode 3 and the light emission function layer 22.

The pixel definition layer 6 is provided with the first opening K1. In other words, when the first opening K1 penetrates through the cathode layer 23 and the light emission function layer 22, the first opening K1 further penetrates through the pixel definition layer 6, to expose the part of the surface of the transfer electrode 3. The pixel definition layer 6 is further provided with a third opening K3, there are a plurality of third openings K3, and the plurality of third openings K3 are disposed in a one-to-one correspondence with a plurality of anodes 21a in the anode layer 21. The third opening K3 exposes a part of a surface of the anode 21a in the anode layer 21, and the light emission function layer 22 is in contact with the anode 21a through the third opening K3.

It should be noted that a light emission area of the light emission device 2a is basically determined by an area of a graphic enclosed by an inner boundary of an orthographic projection of the third opening K3 on the backplane 1. In other words, in the light emission layer 222, light is mainly emitted by a part that is of the light emission layer 222 and that is located within an inner boundary range of the orthographic projection of the third opening K3 on the backplane 1, and a light emission area of the light emission device 2a is equal to or approximately equal to the area of the graphic enclosed by the inner boundary of the orthographic projection of the third opening K3 on the backplane 1.

In some examples, the inner boundary of the orthographic projection of the third opening K3 on the backplane 1 does not overlap the outer boundary of the orthographic projection of the auxiliary cathode 5 on the backplane 1.

This means that the part that is of the light emission layer 222 and that is located within the inner boundary range of the orthographic projection of the third opening K3 on the backplane 1 does not overlap the auxiliary cathode 5. For example, a spacing or an overlapped part exists between the inner boundary of the orthographic projection of the third opening K3 on the backplane 1 and the outer boundary of the orthographic projection of the auxiliary cathode 5 on the backplane 1.

In this way, light emitted by the part that is of the light emission layer 222 and that is located within the inner boundary range of the orthographic projection of the third opening K3 on the backplane 1 is sequentially emitted through the cathode layer 23 and the cathode suppression layer 4, and is basically not incident to the auxiliary cathode 5. Therefore, the auxiliary cathode 5 can be prevented from blocking the light emitted by the light emission layer 222, and impact on light emission efficiency of the light emission device 2a and the display panel 100 is avoided.

In some examples, the inner boundary of the orthographic projection of the third opening K3 on the backplane 1 coincides with an outer boundary of an orthographic projection of the cathode suppression layer 4 on the backplane 1, or is located within an outer boundary range of an orthographic projection of the cathode suppression layer 4 on the backplane 1.

For example, when the inner boundary of the orthographic projection of the third opening K3 on the backplane 1 overlaps the outer boundary of the orthographic projection of the cathode suppression layer 4 on the backplane 1, the cathode suppression layer 4 includes a plurality of independent patterns, and the plurality of patterns are disposed in a one-to-one correspondence with the plurality of third openings K3. In addition, a shape and an area of an orthographic projection of each pattern on the backplane 1 are the same as a shape and an area of the graphic enclosed by the inner boundary of the orthographic projection of the corresponding third opening K3 on the backplane 1. When the inner boundary of the orthographic projection of the third opening K3 on the backplane 1 is located within the outer boundary range of the orthographic projection of the cathode suppression layer 4 on the backplane 1, the cathode suppression layer 4 may be disposed as an entire layer, or may include a plurality of independent patterns, and the plurality of patterns are disposed in a one-to-one correspondence with the plurality of third openings K3. In addition, an area of an orthographic projection of each pattern on the backplane 1 is greater than an area of the graphic enclosed by the inner boundary of the orthographic projection of the corresponding third opening K3 on the backplane 1.

Because the auxiliary cathode 5 does not overlap the cathode suppression layer 4, when the inner boundary of the orthographic projection of the third opening K3 on the backplane 1 overlaps the outer boundary of the orthographic projection of the cathode suppression layer 4 on the backplane 1, the inner boundary of the orthographic projection of the third opening K3 on the backplane 1 may at least partially overlaps the outer boundary of the orthographic projection of the auxiliary cathode 5 on the backplane 1; and when the inner boundary of the orthographic projection of the third opening K3 on the backplane 1 is located within the outer boundary range of the orthographic projection of the cathode suppression layer 4 on the backplane 1, a spacing may exist between the inner boundary of the orthographic projection of the third opening K3 on the backplane 1 and the outer boundary of the orthographic projection of the auxiliary cathode 5 on the backplane 1. In this way, it can be ensured that the inner boundary of the orthographic projection of the third opening K3 on the backplane 1 does not overlap the outer boundary of the orthographic projection of the auxiliary cathode 5 on the backplane 1, to avoid adverse impact on the light emission efficiency of the light emission device 2a and the display panel 100.

It should be noted that there are a plurality of auxiliary signal lines 17, and the plurality of auxiliary signal lines 17 have a plurality of disposing manners, and may be selectively disposed based on an actual requirement. This is not limited in embodiments of this application.

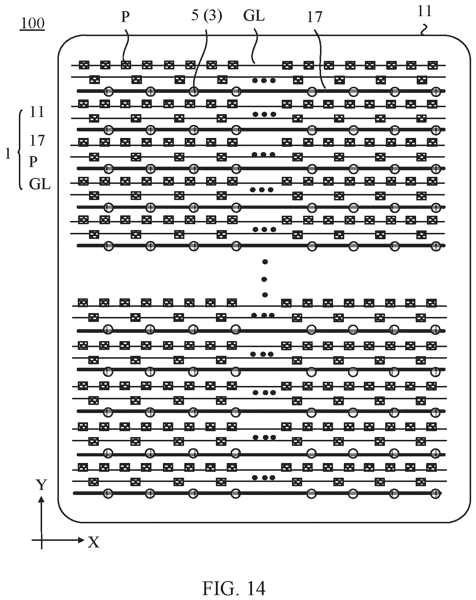

In some examples, as shown in FIG. 14, FIG. 15, and FIG. 17, extension directions of the plurality of auxiliary signal lines 17 are the same. For example, the plurality of auxiliary signal lines 17 all extend in a first direction X, or all extend in a second direction Y, or all extend in a direction other than the first direction X and the second direction Y.

This helps improve arrangement regularity of the auxiliary signal lines 17, and facilitates line distribution design of the auxiliary signal lines 17.

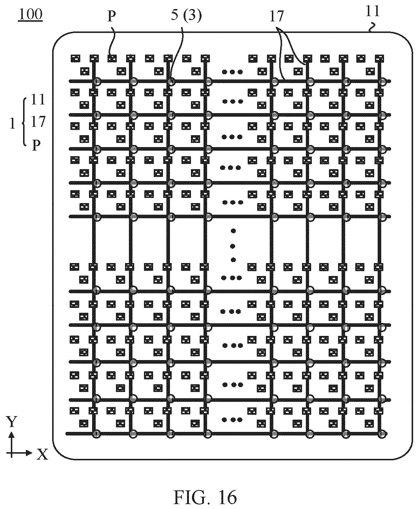

In some other examples, as shown in FIG. 16, at least a part of the plurality of auxiliary signal lines 17 extend in different directions. For example, the at least one auxiliary signal line 17 extends in the first direction X, and at least one auxiliary signal line 17 extends in the second direction Y.

For example, a quantity of auxiliary signal lines 17 extending in the first direction X may be the same as or different from a quantity of auxiliary signal lines 17 extending in the second direction Y. The auxiliary signal line 17 extending in the first direction X and the auxiliary signal line 17 extending in the second direction Y are, for example, spaced and disposed independently from each other.

In this way, more auxiliary signal lines 17 are disposed, distribution density of the auxiliary signal lines 17 is improved, the resistance of the cathode layer 23 is further reduced, and the difference between the voltage drops in different regions of the cathode layer 23 is further reduced.

In some embodiments, as shown in FIG. 13, the backplane 1 includes: a semiconductor layer Poly, at least one gate conducting layer Gate, and at least one source/drain (source/drain) conducting layer SD that are sequentially stacked on the substrate 11. The semiconductor layer Poly includes a channel layer of each transistor in each pixel drive circuit 12. The at least one gate conducting layer Gate includes a gate line GL, an enabling signal line EL, a gate (mainly configured to control conducting or cutting off of a transistor channel) of each transistor, an electrode plate of each storage capacitor, and the like. The at least one source/drain conducting layer SD includes a data line DL, a source and a drain of each transistor, and the like.

In some examples, the auxiliary signal line 17 is located in a target conducting layer, and the target conducting layer includes any layer in the at least one gate conducting layer Gate and the at least one source/drain conducting layer SD.

In other words, in embodiments of this application, the auxiliary signal line 17 is disposed in an existing film layer of the backplane 1, and is formed synchronously with the existing film layer. In this way, an additional film layer can be avoided, increase of thickness of the display panel 100 can be avoided, and increase of preparation processes and preparation costs of the display panel 100 can be avoided.

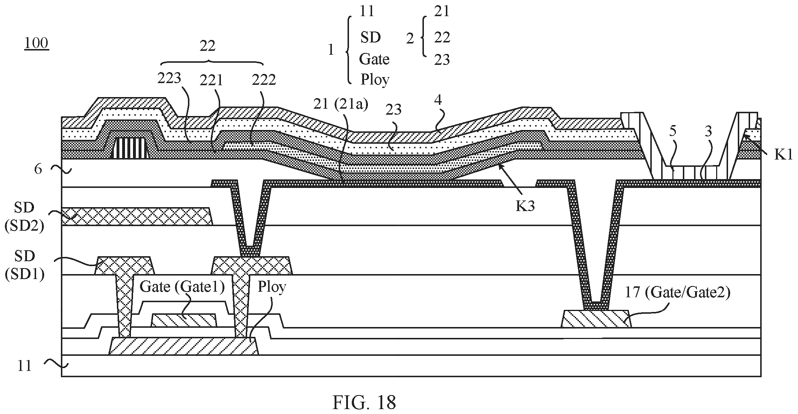

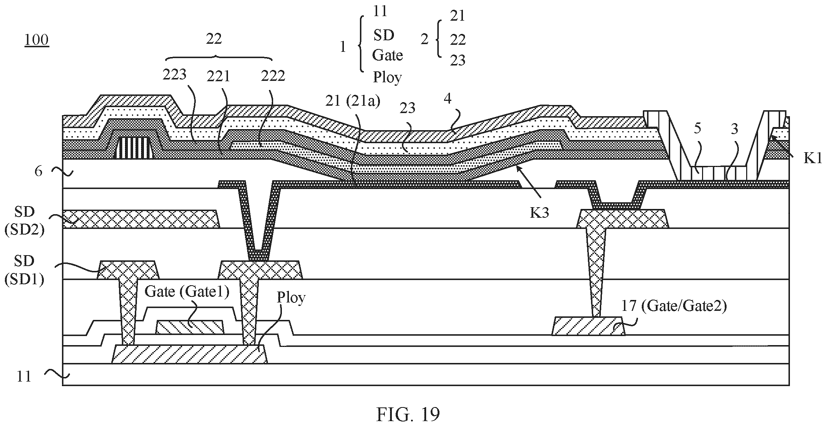

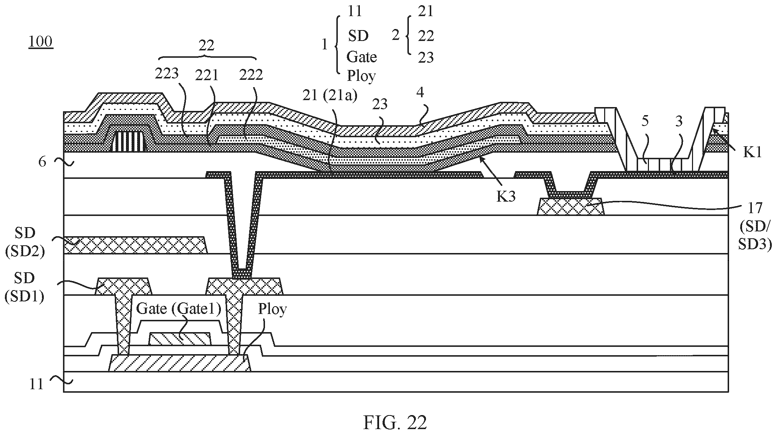

In some examples, as shown in FIG. 18 and FIG. 19, the at least one gate conducting layer Gate includes a first gate conducting layer Gate1 and a second gate conducting layer Gate2 that are disposed in a stacked manner. As shown in FIG. 13, FIG. 20, and FIG. 21, the at least one source/drain conducting layer SD includes a first source/drain conducting layer SD1 and a second source/drain conducting layer SD2 that are disposed in a stacked manner. For example, as shown in FIG. 22, the at least one source/drain conducting layer SD further includes a third source/drain conducting layer SD3 located on the second source/drain conducting layer SD2. Materials of the first gate conducting layer Gate1 and the second gate conducting layer Gate2 include but are not limited to molybdenum (Mo), and materials of the first source/drain conducting layer SD1, the second source/drain conducting layer SD2, and the third source/drain conducting layer SD3 include but are not limited to titanium (Ti)/aluminum (Al)/titanium (Ti).

Optionally, as shown in FIG. 18 and FIG. 19, the target conducting layer is the second gate conducting layer Gate2, that is, the auxiliary signal line 17 is located on the second gate conducting layer Gate2. For example, as shown in FIG. 18, the transfer electrode 3 may be in direct contact with the auxiliary signal line 17, to form an electrical connection. For another example, as shown in FIG. 19, the transfer electrode 3 may be electrically connected to the auxiliary signal line 17 through a lapping electrode. The lapping electrode is, for example, located on the second source/drain conducting layer SD2. Certainly, the lapping electrode may alternatively be located on the first source/drain conducting layer SD1.

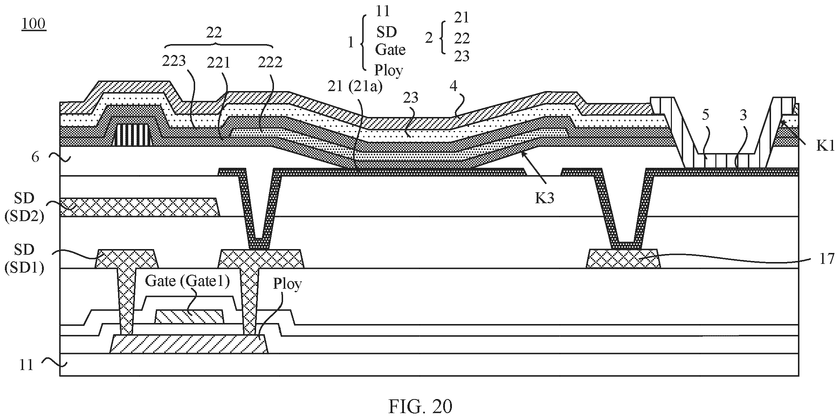

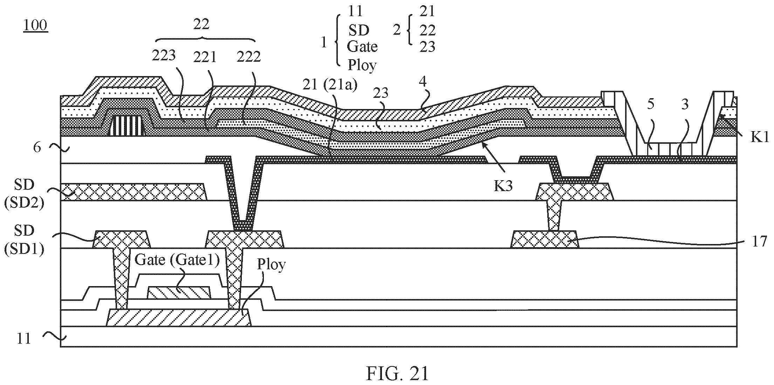

Optionally, as shown in FIG. 20 and FIG. 21, the target conducting layer is the first source/drain conducting layer SD1, that is, the auxiliary signal line 17 is located on the first source/drain conducting layer SD1. For example, as shown in FIG. 18, the transfer electrode 3 may be in direct contact with the auxiliary signal line 17, to form an electrical connection. For another example, as shown in FIG. 19, the transfer electrode 3 may be electrically connected to the auxiliary signal line 17 through a lapping electrode. The lapping electrode is, for example, located on the second source/drain conducting layer SD2.

Optionally, as shown in FIG. 13, the target conducting layer is the second source/drain conducting layer SD2, that is, the auxiliary signal line 17 is located on the second source/drain conducting layer SD2. For example, as shown in FIG. 13, the transfer electrode 3 may be in direct contact with the auxiliary signal line 17, to form an electrical connection.

Optionally, as shown in FIG. 22, the target conducting layer is the third source/drain conducting layer SD3, that is, the auxiliary signal line 17 is located on the third source/drain conducting layer SD3. For example, as shown in FIG. 22, the transfer electrode 3 may be in direct contact with the auxiliary signal line 17, to form an electrical connection.

In some examples, the plurality of gate lines GLs are located on the gate conducting layer Gate. For example, the plurality of gate lines GLs are located on the first gate conducting layer Gate1 and are evenly distributed. The second gate conducting layer Gate2 includes, for example, a signal line configured to transmit another electrical signal (for example, an initial signal), where the signal line extends in the first direction X and is sequentially arranged in the second direction Y. The plurality of data lines DLs are located on the source/drain conducting layer SD. For example, the plurality of data lines DLs are located on the first source/drain conducting layer SD1 and are evenly distributed. The second gate conducting layer Gate2 includes, for example, a signal line configured to transmit another electrical signal (for example, an anode power supply signal ELVDD), where the signal line extends in the second direction Y and is sequentially arranged in the first direction X.

For example, when the plurality of auxiliary signal lines 17 extend in the first direction X and are sequentially arranged in the second direction Y, the plurality of auxiliary signal lines 17 are, for example, located on the first gate conducting layer Gate1 and/or the second gate conducting layer Gate2, to avoid short-circuiting with a signal line located on the source/drain conducting layer SD.

Optionally, at least one gate line GL is disposed between any two adjacent auxiliary signal lines 17. For example, one, two, or three gate lines GLs are disposed between any two adjacent auxiliary signal lines 17. Quantities of gate lines GLs disposed between any two adjacent auxiliary signal lines 17 may be the same, or may be different. FIG. 14 shows that two gate lines GLs are disposed between any two adjacent auxiliary signal lines 17.

For example, when the plurality of auxiliary signal lines 17 extend in the second direction Y and are sequentially arranged in the first direction X, the plurality of auxiliary signal lines 17 are, for example, located on any one of the first source/drain conducting layer SD1, the second source/drain conducting layer SD2, and the third source/drain conducting layer SD3, to avoid short-circuiting with the signal line located on the gate conducting layer Gate.

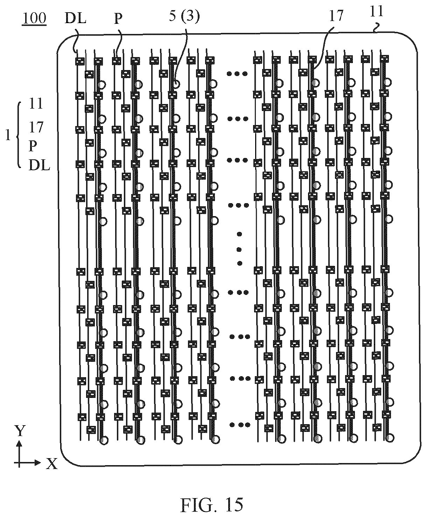

Optionally, at least one data line DL is disposed between any two adjacent auxiliary signal lines 17. For example, one, two, or three data lines DLs are disposed between any two adjacent auxiliary signal lines 17. Quantities of data lines DLs disposed between any two adjacent auxiliary signal lines 17 may be the same, or may be different. FIG. 15 shows that three data lines DLs are disposed between any two adjacent auxiliary signal lines 17.

In some embodiments, there are a plurality of transfer electrodes 3, a plurality of first openings K1, a plurality of second openings K2, and a plurality of auxiliary cathodes 5. The auxiliary signal line 17 is electrically connected to at least one transfer electrode 3, the transfer electrode 3 is disposed in correspondence with at least one first opening K1, the second opening K2 is disposed in correspondence with at least one first opening K1, and the auxiliary cathode 5 is disposed in correspondence with at least one first opening K1.

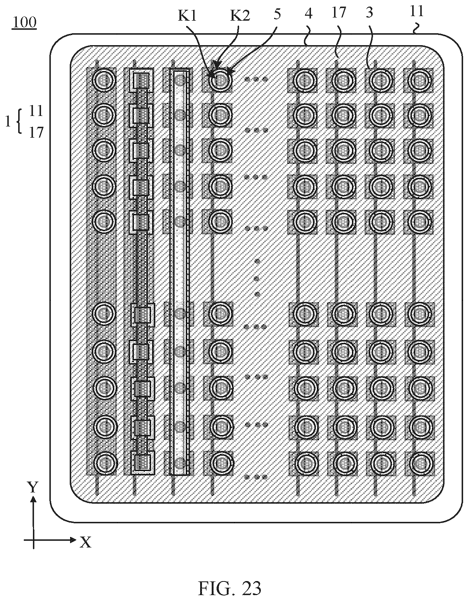

Optionally, as shown in FIG. 6 and FIG. 23, the transfer electrode 3 is in a block shape (including but not limited to a circle, a square, a triangle, a polygon, and the like), and one auxiliary signal line 17 may be electrically connected to a plurality of transfer electrodes 3; and the transfer electrode 3 is in a strip shape, an extension direction of the transfer electrode 3 is the same as an extension direction of the auxiliary signal line 17, and one auxiliary signal line 17 may be electrically connected to one transfer electrode 3.

Optionally, as shown in FIG. 6 and FIG. 23, a shape of the transfer electrode 3 is the same as or similar to the shape of the first opening K1. For example, both the transfer electrode 3 and the first opening K1 are in the block or strip shape, and one transfer electrode 3 is disposed in correspondence with one first opening K1; and the transfer electrode 3 is in the strip shape, the first opening K1 is in the block shape, and one transfer electrode 3 is disposed in correspondence with a plurality of first openings K1.

Optionally, as shown in FIG. 6 and FIG. 23, a shape of the second opening K2 is the same as or similar to the shape of the first opening K1. For example, both the second opening K2 and the first opening K1 are in the block or strip shape, and one second opening K2 is disposed in correspondence with one first opening K1; and the second opening K2 is in the strip shape, the first opening K1 is in the block shape, and one second opening K2 is disposed in correspondence with a plurality of first openings K1.

Optionally, as shown in FIG. 6 and FIG. 23, a shape of the auxiliary cathode 5, the shape of the second opening K2, and the shape of the first opening K1 are the same or similar. For example, the auxiliary cathode 5, the second opening K2, and the first opening K1 are all in the block or strip shape, and one auxiliary cathode 5 is disposed in correspondence with one first opening K1; and the auxiliary cathode 5 and the second opening K2 are both in the strip shape, the first opening K1 is in the block shape, and one auxiliary cathode 5 is disposed in correspondence with a plurality of first openings K1.

The transfer electrode 3 and the auxiliary cathode 5 may have a plurality of distribution manners, and may be selectively disposed based on an actual requirement.

In some examples, as shown in FIG. 6 and FIG. 14 to FIG. 17, the plurality of transfer electrodes 3 are evenly distributed. Alternatively, a plurality of auxiliary cathodes 5 are evenly distributed.

This facilitates layout design of the transfer electrodes 3 or the auxiliary cathodes 5, and helps simplify a preparation process of the display panel 100.

In some examples, in a direction from at least one boundary of the display panel 100 to a center of the display panel 100, distribution density of the transfer electrodes 3 gradually increases, or distribution density of the auxiliary cathodes 5 gradually increases.

It may be understood that a voltage drop at a central location of the cathode layer 23 is greater than a voltage drop at an edge location of the cathode layer 23. The distribution density of the transfer electrodes 3 or the distribution density of the auxiliary cathodes 5 is designed in a gradual changing or differentiated manner, so that in a direction from the edge location of the cathode layer 23 to the central location of the cathode layer 23, an adjustment amount of the cathode layer 23 gradually increases. This helps further reduce the difference between the voltage drops in different regions of the cathode layer 23, and further improve the display brightness uniformity of the display panel 100.

In some embodiments, as shown in FIG. 14 to FIG. 17, the backplane 1 includes a plurality of subpixels P arranged in an array shape. Each subpixel P includes a pixel drive circuit 12 and a light emission device 2a electrically connected to the pixel drive circuit 12.

The transfer electrode 3 or the auxiliary cathode 5 and the subpixel P may have a plurality of location relationships, and may be selectively disposed based on an actual requirement.

In some examples, as shown in FIG. 14 to FIG. 16, both the transfer electrode 3 and the auxiliary cathode 5 are in the block shape, and the transfer electrode 3 and the auxiliary cathode 5 are disposed in a one-to-one correspondence.

The auxiliary cathode 5 is disposed around at least one subpixel P. Because the transfer electrodes 3 and the auxiliary cathodes 5 are disposed in a one-to-one correspondence, a same quantity of transfer electrodes 3 as the auxiliary cathodes 5 are disposed around the at least one subpixel P.

For example, the auxiliary cathode 5 is disposed around each subpixel P. For another example, the auxiliary cathode 5 is disposed around every two subpixels P. For another example, the auxiliary cathode 5 is disposed around every three subpixels P. The quantity of auxiliary cathodes 5 disposed around the at least one subpixel P is, for example, at least one. FIG. 14 to FIG. 16 show that the auxiliary cathode 5 is disposed around every three subpixels P.

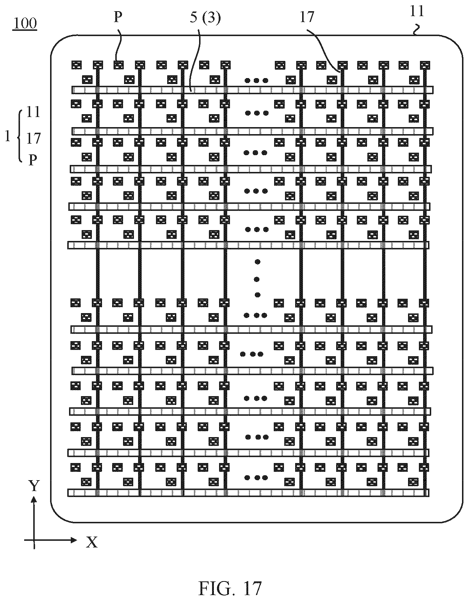

In some other examples, as shown in FIG. 17, the transfer electrode 3 is in the strip shape, the auxiliary cathode 5 is in the strip shape, and the transfer electrode 3 and the auxiliary cathode 5 are disposed in a one-to-one correspondence.

At least one row or at least one column of subpixels P are disposed between two adjacent auxiliary cathodes 5. For example, the auxiliary cathode 5 extends in the first direction X, and a quantity of subpixels P disposed between two adjacent auxiliary cathodes 5 is one row, two rows, three rows, or the like. For another example, the auxiliary cathode 5 extends in the second direction Y, and a quantity of subpixels P disposed between two adjacent auxiliary cathodes 5 is one column, two columns, three columns, or the like. Quantities of subpixels P disposed between two adjacent auxiliary cathodes 5 may be the same or may be different. FIG. 17 shows that the auxiliary cathode 5 extends in the first direction X, and the quantity of subpixels P disposed between any two adjacent auxiliary cathodes 5 is two rows.

In some embodiments, the anode layer 21, the transfer electrode 3, the light emission function layer 22, the cathode suppression layer 4, and the auxiliary cathode 5 are all located in the display region A.

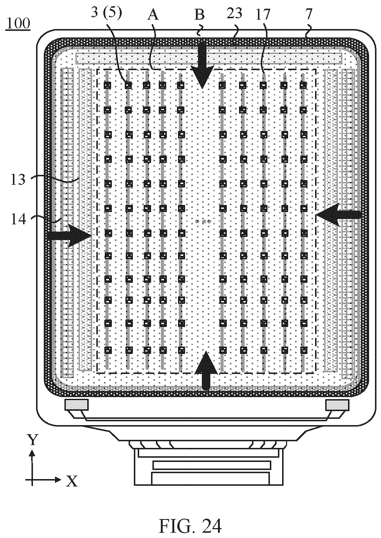

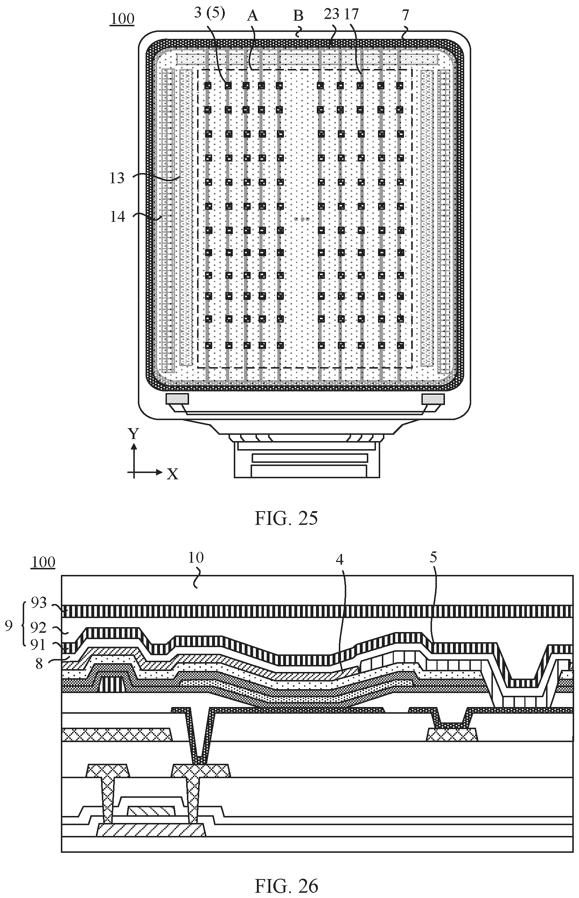

In some examples, the display panel 100 further includes a reference voltage signal line 7 that is located in the peripheral region B and that surrounds at least a part of the display region A. The reference voltage signal line 7 is, for example, disposed on a same layer as the anode layer 21. For example, the reference voltage signal line 7 is located on one side, two sides, or three sides of the display region A, or the reference voltage signal line 7 surrounds the display region A. FIG. 24 and FIG. 25 show that the reference voltage signal line 7 surrounds the display region A, and surrounds the first scanning circuit 13 and the second scanning circuit 14.

A part of the cathode layer 23 is located in the display region A, and the other part of the cathode layer is located in the peripheral region B and is electrically connected to the reference voltage signal line 7. The cathode layer 23 may receive a reference voltage signal ELVSS from the reference voltage signal line 7, so that the light emission device 2a and the display panel 100 work, and the display panel 100 implements picture display.

It may be understood that, in a working process of the display panel 100, the reference voltage signal ELVSS is transmitted to the cathode layer 23 in a direction (a direction indicated by an arrow in FIG. 24) from any side edge of the display panel 100 to a center of the display panel 100. A voltage drop problem exists on the cathode layer 23 in a transmission direction of the reference voltage signal ELVSS.

In an implementation, the foregoing voltage drop problem may be improved by increasing thickness of the cathode layer 23 or increasing a width of the reference voltage signal line 7. However, increasing the thickness of the cathode layer 23 reduces light emission efficiency, increasing the width of the reference voltage signal line 7 increases a frame size, and it is difficult to resolve a problem of uneven display brightness caused by the transmission direction of the reference voltage signal ELVSS. In embodiments of this application, the auxiliary signal line 17 is disposed, and the auxiliary signal line 17 and the cathode layer 23 are connected in parallel, so that a resistance of the cathode layer 23 can be reduced by using the auxiliary signal line 17, and voltage drops in different regions of the cathode layer 23 can be adjusted. In this way, the voltage drops in different regions of the cathode layer 23 tend to be consistent, and display brightness uniformity is improved. In addition, the display panel 100 can further have high light emission efficiency and a narrow frame.

In some examples, as shown in FIG. 25, the auxiliary signal line 17 is electrically connected to the reference voltage signal line 7. The reference voltage signal ELVSS provided by the reference voltage signal line 7 may be directly transmitted to the cathode layer 23, or may be transmitted to the cathode layer 23 through the auxiliary signal line 17, the transfer electrode 3, and the auxiliary cathode 5, so that the reference voltage signal ELVSS can be received at different locations in the cathode layer 23.

This helps further make voltages of the cathode layer 23 in the entire display region tend to be consistent, and further improve display brightness uniformity of the display panel 100.

In some embodiments, as shown in FIG. 26, the display panel 100 further includes an encapsulation layer 9 and a touch function layer 10.

The encapsulation layer 9 is located on the cathode suppression layer 4 and the auxiliary cathode 5. The encapsulation layer 9 includes a first inorganic layer 91, an organic layer 92, and a second inorganic layer 93 that are sequentially stacked. The first inorganic layer 91 and the second inorganic layer 93 are mainly configured to isolate water vapor and/or oxygen, and the organic layer 92 is mainly configured to perform planarization. The encapsulation layer 9 is disposed, encapsulation protection can be performed on the light emission device, to avoid corrosion of the light emission device by water vapor and/or oxygen, and avoid affecting service life of the light emission device and the display panel 100. The first inorganic layer 91 and the second inorganic layer 93 are separately formed, for example, by using a chemical vapor deposition (chemical vapor deposition, CVD) process. The first inorganic layer 91 is also referred to as a CVD1, and the second inorganic layer 93 is also referred to as a CVD2. The organic layer 92 is, for example, formed by using ink jet printing (ink jet printing, IJP), and thickness of the organic layer 92 is, for example, about 10 µm.

The touch function layer 10 is located on the encapsulation layer 9. The touch function layer 10 includes, for example, a first touch electrode layer, a dielectric layer, and a second touch electrode layer that are sequentially stacked in a direction away from the backplane 1. The touch function layer 10 is integrated on the encapsulation layer 9, to form a TOE (touch on encapsulation) structure, so that the display panel 100 has both a display function and a touch function.

In an implementation, the touch function is usually implemented in a peripheral touch manner. However, the peripheral touch manner obviously increases thickness, a weight, a frame size, costs, and the like of the display panel. In addition, when the display panel is used in a foldable product, bending experience of the foldable product is affected, and problems such as large rebound force and a deep crease exist.

In embodiments of this application, the TOE structure is used, so that the thickness, the weight, the frame size, the costs, and the like of the display panel 100 can be greatly reduced. In addition, when the display panel 100 is used in the foldable product, folding of the foldable product is facilitated, and bending experience of the foldable product is improved.

It may be understood that, in the foregoing TOE structure, a spacing between the touch function layer and the cathode layer is small, and a coupling capacitor is easily generated between the touch function layer and the cathode layer. If voltage drops in different regions of the cathode layer are different, a reference voltage signal in the cathode layer has voltage fluctuation, which causes interference to the touch function layer. Consequently, a signal-to-noise ratio (signal-to-noise ratio, SNR) of the touch function layer is poor. The signal-to-noise ratio is an indicator of standard signal quality, and is calculated by using a ratio of a semaphore to a noise amount. However, a touch signal of the touch function layer causes interference to the reference voltage signal of the cathode layer, causing a display exception (for example, a water ripple).

In an implementation, the thickness of the cathode layer or thickness of the organic layer of the encapsulation layer is usually increased, to increase a spacing between the cathode layer and the touch function layer, and improve the signal-to-noise ratio of the touch function layer. However, increasing the thickness of the cathode layer or the organic layer reduces light emission efficiency of the display panel, and further affects display brightness of the display panel or increases power consumption of the display panel. In addition, when the display panel is used in the foldable product, increasing the thickness of the organic layer is not conducive to a folding function of the display panel.

In embodiments of this application, the auxiliary signal line 17 is disposed, and the auxiliary signal line 17 and the cathode layer 23 are disposed in parallel, so that the voltage drops in different regions of the cathode layer 23 tend to be consistent, voltages of the cathode layer 23 in the entire display region tend to be consistent, and voltage fluctuation in the cathode layer 23 is reduced. In this way, the stability of the voltage in the cathode layer 23 is effectively improved, a capacitive coupling amount of the touch function layer 10 can be greatly reduced, a signal-to-noise ratio of the touch function layer 10 can be improved, and a water ripple phenomenon of the display panel 100 can be further improved. In addition, increase of the thickness of the cathode layer 23 or the organic layer 92 can be avoided, to ensure that the display panel 100 has high light emission efficiency and low power consumption, and avoid affecting a folding function of the display panel 100 when the display panel is used in a foldable product.

In some examples, as shown in FIG. 26, the display panel 100 further includes a dimming layer 8 located between the cathode suppression layer 4 and the encapsulation layer 9 and between the auxiliary cathode 5 and the encapsulation layer 9. The dimming layer 8 includes, for example, a capping layer (CPL) and a lithium fluoride (LiF) film layer that are sequentially stacked, and the dimming layer 8 may cooperate with the encapsulation layer 9 to complete encapsulation.

For example, the capping layer has a large refractive index and a small light absorption coefficient, so that light emission efficiency can be improved. The lithium fluoride film layer is an inorganic film layer having a low refractive index, and is configured to adjust light emission.

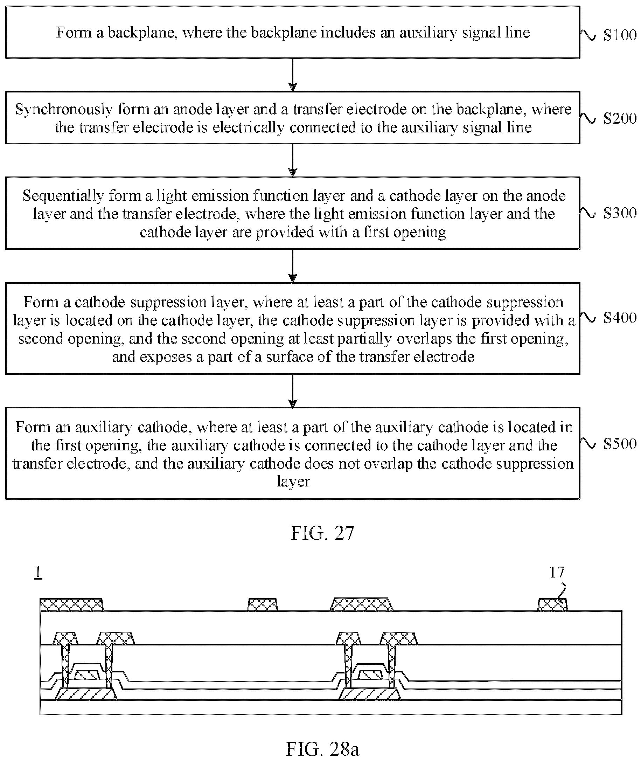

Some embodiments of this application further provide a display panel preparation method. As shown in FIG. 27, the preparation method includes S100 to S500.

S100: As shown in FIG. 28a, form a backplane 1, where the backplane 1 includes an auxiliary signal line 17.

For a structure of the backplane 1 and a disposing location and a disposing manner of the auxiliary signal line 17, refer to the foregoing descriptions. Details are not described herein again.

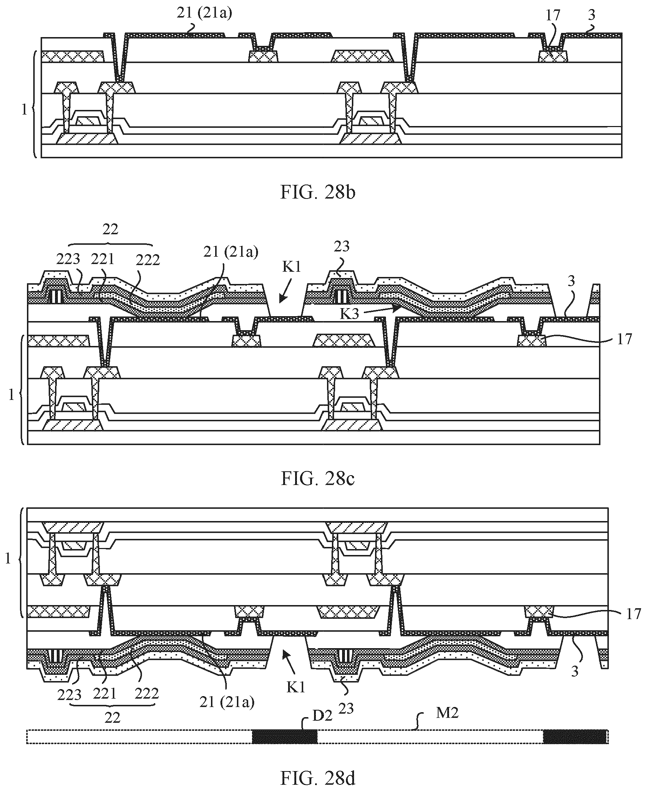

S200: As shown in FIG. 28b, synchronously form an anode layer 21 and a transfer electrode 3 on the backplane 1, where the transfer electrode 3 is electrically connected to the auxiliary signal line 17.

For example, before the anode layer 21 and the transfer electrode 3 are formed, a planar layer (PLN) may be first formed on the backplane 1. A material of the planar layer includes an organic material. The planar layer may be disposed for planarization, to provide a flat surface for the subsequently formed anode layer 21 and transfer electrode 3, to ensure structure stability of the formed anode layer 21 and transfer electrode 3.

For example, in embodiments of this application, a first conducting thin film may be formed on the planar layer by using a sputtering process or a deposition process. A material of the first conducting thin film includes, for example, a metal material. Then, the first conducting thin film may be etched to obtain the anode layer 21 and the transfer electrode 3. The transfer electrode 3 may pass through the planar layer to be in contact with the auxiliary signal line 17, to form an electrical connection. The anode layer 21 and the transfer electrode 3 are independent of each other, and the anode layer 21 includes a plurality of anodes 21a that are independent of each other.

S300: As shown in FIG. 28c, sequentially form a light emission function layer 22 and a cathode layer 23 on the anode layer 21 and the transfer electrode 3, where the light emission function layer 22 and the cathode layer 23 are provided with a first opening K1.

For example, before the light emission function layer 22 and the cathode layer 23 are formed, a yellow light process may be used to first form a pixel definition layer 6 on the anode layer 21 and the transfer electrode 3. The pixel definition layer 6 is provided with the first opening K1 and a third opening K3, the first opening K1 exposes a part of a surface of the transfer electrode 3, and the third opening K3 exposes a part of a surface of the anode 21a.

For example, in embodiments of this application, the light emission function layer 22 and the cathode layer 23 may be formed by using an evaporation process. The light emission function layer 22 is in contact with the anode 21a through the third opening K3. For a structure of the light emission function layer 22, refer to the foregoing descriptions. Details are not described herein again.

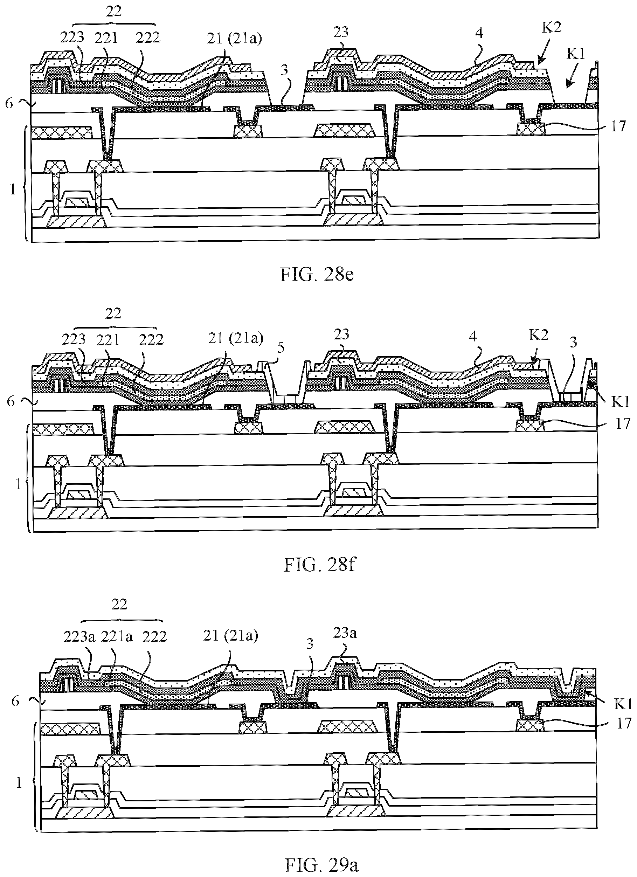

S400: As shown in FIG. 28d and FIG. 28e, form a cathode suppression layer 4, where at least a part of the cathode suppression layer 4 is located on the cathode layer 23, the cathode suppression layer 4 is provided with a second opening K2, and the second opening K2 at least partially overlaps the first opening K1, and exposes a part of a surface of the transfer electrode 3.

For example, in embodiments of this application, the cathode suppression layer 4 may be formed by using the evaporation process.

Optionally, the forming a cathode suppression layer 4 in S400 includes S410 to S420.

S410: As shown in FIG. 28d, dispose a second mask M2 on a side of the cathode layer 23, where the second mask M2 has a second stopper D2, and the second stopper D2 blocks at least a part of the first opening K1.

A location and an area of the second stopper D2 are determined based on a location and an area of the to-be-formed second opening. The second mask M2 is, for example, a fine metal mask (fine metal mask, FMM).

Optionally, an outer boundary of an orthographic projection of the first opening K1 on the backplane 1 coincides with an inner boundary of an orthographic projection of the to-be-formed second opening on the backplane 1. In this case, the second stopper D2 is directly opposite to the first opening K1, and completely blocks the first opening K1, and an area of the second stopper D2 is equal to or approximately equal to an area of a graphic enclosed by the outer boundary of the orthographic projection of the first opening K1 on the backplane 1.

Optionally, an outer boundary of an orthographic projection of the first opening K1 on the backplane 1 is located within an inner boundary range of an orthographic projection of the to-be-formed second opening on the backplane 1. In this case, the second stopper D2 is directly opposite to the first opening K1, and completely blocks the first opening K1, and an area of the second stopper D2 is greater than an area of a graphic enclosed by the outer boundary of the orthographic projection of the first opening K1 on the backplane 1, as shown in FIG. 28d.

Optionally, an outer boundary of an orthographic projection of the first opening K1 on the backplane 1 intersects with an inner boundary of an orthographic projection of the to-be-formed second opening on the backplane 1. In this case, the second stopper D2 is staggered with the first opening K1, and the second stopper D2 blocks a part of the first opening K1. A value relationship between the area of the second stopper D2 and the area of the graphic enclosed by the outer boundary of the orthographic projection of the first opening K1 on the backplane 1 is determined based on an actual requirement.

S420: As shown in FIG. 28e, form the cathode suppression layer 4 on the cathode layer 23 by using the evaporation process, and form the second opening K2 at a location that is on the cathode suppression layer 4 and that corresponds to the second stopper D2.

Before the cathode suppression layer is formed through evaporation, for example, the structure obtained in S300 is turned over by 180°, as shown in FIG. 28d, and then a material of the cathode suppression layer 4 is evaporated. In an evaporation process, a part of the material of the cathode suppression layer 4 may pass through a part that is of the second mask M2 and on which no second stopper D2 is disposed, and is attached to the cathode layer 23, and the other part of the material of the cathode suppression layer 4 is blocked by the second stopper D2, so that the cathode suppression layer 4 formed through evaporation is provided with the second opening K2.

When the outer boundary of the orthographic projection of the first opening K1 on the backplane 1 coincides with the inner boundary of the orthographic projection of the second opening K2 on the backplane 1, or is located within the inner boundary range of the orthographic projection of the second opening K2 on the backplane 1, the cathode suppression layer 4 is entirely located on the cathode layer 23, and the second opening K2 is fully connected to the first opening K1.

When the outer boundary of the orthographic projection of the first opening K1 on the backplane 1 intersects with the inner boundary of the orthographic projection of the second opening K2 on the backplane 1, the material of the cathode suppression layer 4 is evaporated to a part that is of the first opening K1 and that is not blocked by the second stopper D2, and is attached to a part of a side wall of the first opening K1, so that a part of the obtained cathode suppression layer 4 is located in the first opening K1. The entire cathode suppression layer 4 has a recess, and a part that is of the cathode suppression layer 4 and that surrounds the second opening K2 is no longer located on a same plane. In comparison with the first opening K1, the second opening K2 is an irregular opening, and the second opening K2 and the first opening K1 share a part.

S500: As shown in FIG. 28f, form an auxiliary cathode 5, where at least a part of the auxiliary cathode 5 is located in the first opening K1, the auxiliary cathode 5 is connected to the cathode layer 23 and the transfer electrode 3, and the auxiliary cathode 5 does not overlap the cathode suppression layer 4.

For example, in embodiments of this application, the auxiliary cathode 5 may be formed by using the evaporation process.

The material of the cathode suppression layer 4 and a material of the auxiliary cathode 5 have small adhesive, or even repels each other. In a process of evaporating the material of the auxiliary cathode 5, the material of the auxiliary cathode 5 is attached to a location other than the cathode suppression layer 4, and basically there is no material of the auxiliary cathode 5 on a surface of the cathode suppression layer 4. Therefore, the auxiliary cathode 5 does not overlap the cathode suppression layer 4.

The display panel preparation method provided in embodiments of this application is, for example, used to prepare the display panel 100 provided in some of the foregoing embodiments. Beneficial effect that can be implemented by the preparation method is the same as the beneficial effect that can be implemented by the display panel 100 provided in some of the foregoing embodiments. Details are not described herein again.

In the foregoing S300, there are a plurality of methods for sequentially forming the light emission function layer 22 and the cathode layer 23 on the anode layer 21 and the transfer electrode 3, which may be selectively disposed based on an actual requirement.

In some examples, the sequentially forming the light emission function layer 22 and the cathode layer 23 on the anode layer 21 and the transfer electrode 3 includes S310a and S320a.

S310a: As shown in FIG. 29a, sequentially form a light emission function thin film 22a and a cathode thin film 23a on the anode layer 21 and the transfer electrode 3.

For example, the light emission function thin film 22a includes a first common thin film 221a, a light emission layer 222, and a second common thin film 223a that are sequentially stacked. The first common thin film 221a includes but is not limited to a hole injection thin film and/or a hole transportation thin film, and the second common layer 223 includes but is not limited to an electron injection thin film and/or an electron transportation thin film. The light emission layer 222 includes but is not limited to a red light emission layer, a green light emission layer, and a blue light emission layer.

In embodiments of this application, for example, a common metal mask (common metal mask, CMM) is disposed on a side of the anode layer 21 and the transfer electrode 3, and a material (for example, an organic material) of the first common thin film 221a is evaporated by using the evaporation process, to form the first common thin film 221a on the anode layer 21 and the transfer electrode 3. Then, an FMM is disposed on a side of the first common thin film 221a, and a material (for example, an organic material) of the light emission layer 222 is evaporated by using the evaporation process, to form the light emission layer 222. Then, a CMM is disposed on a side of the light emission layer 222, and a material (for example, an organic material) of the second common thin film 223a is evaporated by using the evaporation process, to form the second common thin film 223a on the light emission layer 222.

In a process of forming the light emission layer 222 through evaporation, the light emission layer 222 of a same color may be formed through evaporation each time. In this way, a plurality of light emission layers 222 may be formed in a plurality of times.

For example, in embodiments of this application, for example, the CMM is disposed on a side of the second common thin film 223a, and a material (for example, a metal material) of a cathode thin film 23a is evaporated by using an evaporation process, to form the cathode thin film 23a.

It may be understood that the light emission function thin film 22a and the cathode thin film 23a form a recess at a location of the first opening K1 on the pixel defining layer 6.

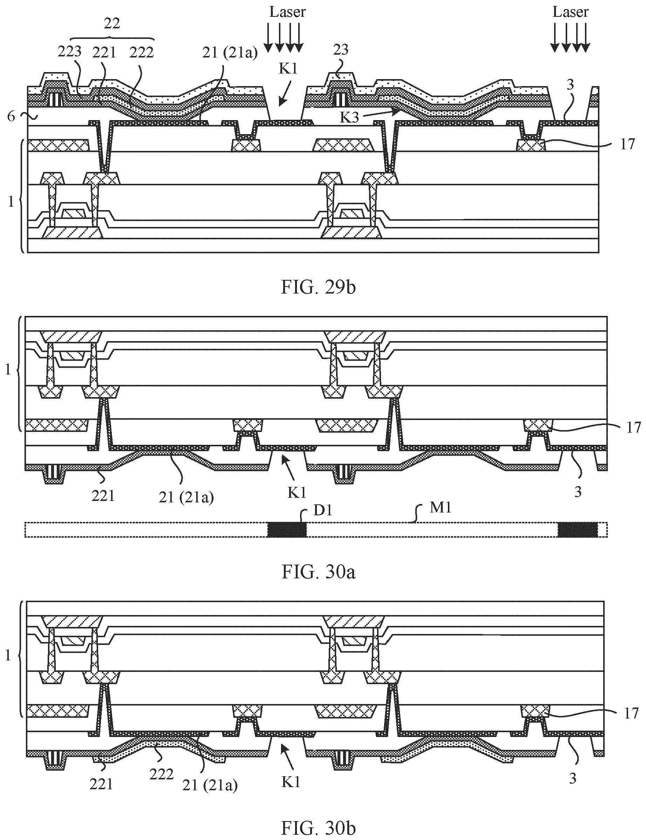

S320a: As shown in FIG. 29b, perform, by using a laser process, ablation on parts that are of the light emission function thin film 22a and the cathode thin film 23a and that are opposite to the transfer electrode 3, to form the first opening K1, and obtain the light emission function layer 22 and the cathode layer 23.

For example, the parts that are of the light emission function thin film 22a and the cathode thin film 23a and that are opposite to the transfer electrode 3 are, for example, recessed parts of the light emission function thin film 22a and the cathode thin film 23a, or parts that are of the light emission function thin film 22a and the cathode thin film 23a and that correspond to the first opening K1 on the pixel defining layer 6.

In the foregoing laser process, laser light is incident to the parts that are of the light emission function thin film 22a and the cathode thin film 23a and that are opposite to the transfer electrode 3, and the parts are ablated and removed, to obtain the light emission function layer 22 and the cathode layer 23. The first opening K1 penetrates through the light emission function layer 22, the cathode layer 23, and the pixel definition layer 6.

In some other examples, the sequentially forming the light emission function layer 22 and the cathode layer 23 on the anode layer 21 and the transfer electrode 3 includes S310b and S320b.

S310b: Dispose a first mask M1 on a side of the anode layer 21 and the transfer electrode 3, where the first mask M1 has a first stopper D1, and the first stopper D1 blocks a part of the transfer electrode 3.

S320b: As shown in FIG. 30a to FIG. 30c, sequentially form the light emission function layer 22 and the cathode layer 23 by using the evaporation process, and form the first opening K1 at a location that is on the light emission function layer 22 and the cathode layer 23 and that corresponds to the first stopper D1.

A location and an area of the first stopper D1 are determined based on a location and an area of a to-be-formed first opening. The first mask M1 is, for example, a fine metal mask (fine metal mask, FMM).

The light emission function layer 22 includes a first common layer 221, a light emission layer 222, and a second common layer 223 that are sequentially stacked.

As shown in FIG. 30a, in embodiments of this application, for example, the first mask M1 is disposed on a side of the anode layer 21 and the transfer electrode 3, and then a material of the first common layer 221 is evaporated by using the evaporation process. In the evaporation process, a part of the material of the first common layer 221 may pass through a part that is of the first mask M1 and on which no first stopper D1 is disposed, and is attached to the pixel definition layer 6, and the other part of material of the first common layer 221 is blocked by the first stopper D1.

As shown in FIG. 30b, in embodiments of this application, for example, the FMM is disposed on a side of the first common layer 221, and a material (for example, an organic material) of the light emission layer 222 is evaporated by using the evaporation process, to form the light emission layer 222. In a process of forming the light emission layer 222 through evaporation, the light emission layer 222 of a same color may be formed through evaporation each time. In this way, a plurality of light emission layers 222 may be formed in a plurality of times.

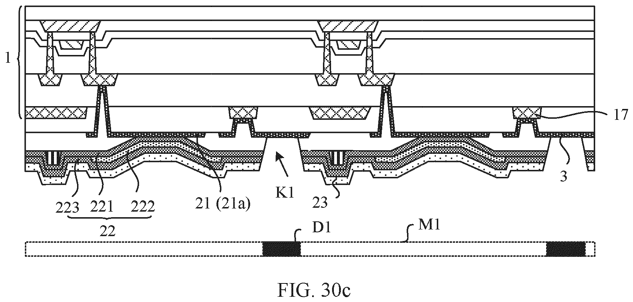

As shown in FIG. 30c, in embodiments of this application, for example, the first mask M1 is disposed on a side of the light emission layer 222, and then a material of the second common layer 223 is evaporated by using the evaporation process. In the evaporation process, a part of the material of the second common layer 223 may pass through the part that is of the first mask M1 and on which no first stopper D1 is disposed, and is attached to the light emission layer 222 and the first common layer 221, and the other part of the material of the second common layer 223 is blocked by the first stopper D1. Then, a material (for example, a metal material) of the cathode layer 23 is evaporated by using the evaporation process, to form the cathode layer 23. In the evaporation process, a part of the material of the cathode layer 23 may pass through the part that is of the first mask M1 and on which no first stopper D1 is disposed, and is attached to the second common layer 223, and the other part of the material of the cathode layer 23 is blocked by the first stopper D1.

In this way, the first opening K1 may be formed, and the light emission function layer 22 and the cathode layer 23 are obtained.

The foregoing descriptions are merely specific implementations of this application, but are not intended to limit the protection scope of this application. Any variation or replacement readily figured out by a person skilled in the art within the technical scope disclosed in the present disclosure shall fall within the protection scope of this application. Therefore, the protection scope of this application shall be subject to the protection scope of the claims.

## Claims

1. A display panel, wherein the display panel comprises:
a backplane, comprising an auxiliary signal line;
an anode layer and a transfer electrode that are located on the backplane, wherein the transfer electrode and the anode layer are disposed on a same layer, and the transfer electrode is electrically connected to the auxiliary signal line;
a light emission function layer and a cathode layer that are located on the anode layer and the transfer electrode and that are sequentially stacked, wherein the light emission function layer and the cathode layer are provided with a first opening;
a cathode suppression layer, wherein at least a part of the cathode suppression layer is located on the cathode layer, the cathode suppression layer is provided with a second opening, and the second opening at least partially overlaps the first opening, and exposes a part of a surface of the transfer electrode; and
an auxiliary cathode, wherein at least a part of the auxiliary cathode is located in the first opening, the auxiliary cathode is connected to the cathode layer and the transfer electrode, and the auxiliary cathode does not overlap the cathode suppression layer.

2. The display panel according to claim 1, wherein the cathode suppression layer is located on the cathode layer, and an outer boundary of an orthographic projection of the first opening on the backplane coincides with an inner boundary of an orthographic projection of the second opening on the backplane; and
the auxiliary cathode is located in the first opening, and abuts against a part that is of the cathode layer and that surrounds the first opening.

3. The display panel according to claim 1, wherein the cathode suppression layer is located on the cathode layer, and an outer boundary of an orthographic projection of the first opening on the backplane is located within an inner boundary range of an orthographic projection of the second opening on the backplane; or
a part of the cathode suppression layer is located on the cathode layer, the other part of the cathode suppression layer covers a part of a side wall of the first opening, and an outer boundary of an orthographic projection of the first opening on the backplane intersects with an inner boundary of an orthographic projection of the second opening on the backplane; and
a part of the auxiliary cathode is located in the first opening, and the other part of the auxiliary cathode is lapped on the cathode layer.

4. The display panel according to claim 3, wherein when the cathode suppression layer is located on the cathode layer, and the outer boundary of the orthographic projection of the first opening on the backplane is located within the inner boundary range of the orthographic projection of the second opening on the backplane,
an area of an orthographic projection of the auxiliary cathode on the backplane is greater than an area of a graphic enclosed by the outer boundary of the orthographic projection of the first opening on the backplane.

5. The display panel according to claim 3, wherein when the cathode suppression layer is located on the cathode layer, and the outer boundary of the orthographic projection of the first opening on the backplane is located within the inner boundary range of the orthographic projection of the second opening on the backplane,
the part that is of the auxiliary cathode and that is lapped on the cathode layer is in a ring shape; or
when the part of the cathode suppression layer is located on the cathode layer, the other part of the cathode suppression layer covers the part of the side wall of the first opening, and the outer boundary of the orthographic projection of the first opening on the backplane intersects with the inner boundary of the orthographic projection of the second opening on the backplane,
the part that is of the auxiliary cathode and that is lapped on the cathode layer is in a "C" shape or a "-" shape.

6. The display panel according to claim 1, wherein thickness of the auxiliary cathode is greater than or equal to thickness of the cathode layer.

7. The display panel according to claim 1, wherein the anode layer comprises an anode;
the display panel further comprises a pixel definition layer located between the anode layer and the light emission function layer, wherein the pixel definition layer is provided with the first opening and a third opening that exposes a part of a surface of the anode, and the light emission function layer is in contact with the anode through the third opening; and
an inner boundary of an orthographic projection of the third opening on the backplane does not overlap an outer boundary of an orthographic projection of the auxiliary cathode on the backplane.

8. The display panel according to claim 7, wherein the inner boundary of the orthographic projection of the third opening on the backplane coincides with an outer boundary of an orthographic projection of the cathode suppression layer on the backplane, or is located within an outer boundary range of an orthographic projection of the cathode suppression layer on the backplane.

9. The display panel according to claim 1, wherein there are a plurality of auxiliary signal lines; and
extension directions of the plurality of auxiliary signal lines are the same; or
at least one auxiliary signal line extends in a first direction, and at least one auxiliary signal line extends in a second direction, wherein the first direction intersects with the second direction.

10. The display panel according to claim 9, wherein a plurality of transfer electrodes are evenly distributed, or a plurality of auxiliary cathodes are evenly distributed.

11. The display panel according to claim 9, wherein in a direction from at least one boundary of the display panel to a center of the display panel, distribution density of the transfer electrodes gradually increases, or distribution density of the auxiliary cathodes gradually increases.

12. The display panel according to claim 9, wherein the backplane comprises a plurality of subpixels arranged in an array shape; and
both the transfer electrode and the auxiliary cathode are in a block shape, the transfer electrode and the auxiliary cathode are disposed in a one-to-one correspondence, and the auxiliary cathode is disposed around the at least one subpixel; or
the transfer electrode is in a strip shape, the auxiliary cathode is in a strip shape, the transfer electrode and the auxiliary cathode are disposed in a one-to-one correspondence, and at least one row or at least one column of subpixels are disposed between two adjacent auxiliary cathodes.

13. The display panel according to claim 1, wherein the backplane comprises:
a substrate; and
a semiconductor layer, at least one gate conducting layer, and at least one source/drain conducting layer that are sequentially stacked on the substrate, wherein
the auxiliary signal line is located in a target conducting layer, and the target conducting layer comprises any layer in the at least one gate conducting layer and the at least one source/drain conducting layer.

14. The display panel according to claim 13, wherein there are a plurality of auxiliary signal lines; and
the gate conducting layer comprises a plurality of gate lines that extend in a first direction and that are sequentially arranged in a second direction, the first direction is perpendicular to the second direction, at least a part of auxiliary signal lines extend in the first direction and are sequentially arranged in the second direction, and at least one gate line is disposed between any two adjacent auxiliary signal lines; and/or
the source/drain conducting layer comprises a plurality of data lines that extend in the second direction and that are sequentially arranged in the first direction, at least a part of auxiliary signal lines extend in the second direction and are sequentially arranged in the first direction, and at least one data line is disposed between any two adjacent auxiliary signal lines.

15. The display panel according to claim 1, wherein the display panel has a display region and a peripheral region surrounding the display region;
the anode layer, the transfer electrode, the light emission function layer, the cathode suppression layer, and the auxiliary cathode are all located in the display region; and
the display panel further comprises a reference voltage signal line that is located in the peripheral region and that surrounds at least a part of the display region, a part of the cathode layer is located in the display region, and the other part of the cathode layer is located in the peripheral region and is electrically connected to the reference voltage signal line.

16. The display panel according to claim 15, wherein the auxiliary signal line is electrically connected to the reference voltage signal line.

17. The display panel according to claim 1, wherein the display panel further comprises:
an encapsulation layer located on the cathode suppression layer and the auxiliary cathode; and
a touch function layer located on the encapsulation layer.

18. A display panel preparation method, wherein the preparation method comprises:
forming a backplane, wherein the backplane comprises an auxiliary signal line;
synchronously forming an anode layer and a transfer electrode on the backplane, wherein the transfer electrode is electrically connected to the auxiliary signal line;
sequentially forming a light emission function layer and a cathode layer on the anode layer and the transfer electrode, wherein the light emission function layer and the cathode layer are provided with a first opening;
forming a cathode suppression layer, wherein at least a part of the cathode suppression layer is located on the cathode layer, the cathode suppression layer is provided with a second opening, and the second opening at least partially overlaps the first opening, and exposes a part of a surface of the transfer electrode; and
forming an auxiliary cathode, wherein at least a part of the auxiliary cathode is located in the first opening, the auxiliary cathode is connected to the cathode layer and the transfer electrode, and the auxiliary cathode does not overlap the cathode suppression layer.

19. The preparation method according to claim 18, wherein the sequentially forming a light emission function layer and a cathode layer on the anode layer and the transfer electrode comprises:
sequentially forming a light emission function thin film and a cathode thin film on the anode layer and the transfer electrode; and
performing, by using a laser process, ablation on parts that are of the light emission function thin film and the cathode thin film and that are opposite to the transfer electrode, to form the first opening, and obtain the light emission function layer and the cathode layer; or
the sequentially forming a light emission function layer and a cathode layer on the anode layer and the transfer electrode comprises:
disposing a first mask on a side of the anode layer and the transfer electrode, wherein the first mask has a first stopper, and the first stopper blocks a part of the transfer electrode; and
sequentially performing evaporation by using an evaporation process, to form the light emission function layer and the cathode layer, wherein the first opening is formed at a location that is on the light emission function layer and the cathode layer and that corresponds to the first stopper.

20. An electronic device, wherein the electronic device comprises a display panel and an integrated circuit electrically connected to the display panel, and the display panel comprises the display panel according to any one of claims 1 to 17.
